(19)

Europäisches Patentamt
European Patent Office
Office européen des brevets

(11)  **EP 4 475 359 A1**

(12)  # EUROPEAN PATENT APPLICATION
published in accordance with Art. 153(4) EPC

(43) Date of publication:
**11.12.2024 Bulletin 2024/50**

(21) Application number: **23769672.9**

(22) Date of filing: **10.03.2023**

(51) International Patent Classification (IPC):
*H01S 3/10* (2006.01)        *G02F 1/35* (2006.01)

(52) Cooperative Patent Classification (CPC):
**G02F 1/35; H01S 3/10; H01S 3/108; H01S 5/06;**
**H01S 5/062; H04B 10/40**

(86) International application number:
**PCT/CN2023/080690**

(87) International publication number:
**WO 2023/174168 (21.09.2023 Gazette 2023/38)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **17.03.2022 CN 202210265993**

(71) Applicant: **Huawei Technologies Co., Ltd.**
**Shenzhen, Guangdong 518129 (CN)**

(72) Inventors:
• **LIU, Chen**
  **Shenzhen, Guangdong 518129 (CN)**
• **GUI, Chengcheng**
  **Shenzhen, Guangdong 518129 (CN)**
• **ZHOU, Heng**
  **Shenzhen, Guangdong 518129 (CN)**

(74) Representative: **Isarpatent**
**Patent- und Rechtsanwälte**
**Barth Hassa Peckmann & Partner mbB**
**Friedrichstraße 31**
**80801 München (DE)**

(54)  **OPTICAL FREQUENCY COMB GENERATION DEVICE AND METHOD, LIGHT EMISSION DEVICE, AND OPTICAL COMMUNICATION SYSTEM**

(57)    An optical frequency comb generation device (100) and method, a light emission device (200), and an optical communication system (700) are provided, and are applied to scenarios such as optical communication and laser radar. The optical frequency comb generation device (100) includes a laser device (10), an optical splitter (20), a frequency shifter (30), and an optical microcavity (40). The laser device (10) is configured to generate a source scanning light beam whose frequency changes in a first direction. The optical splitter (20) is configured to split the source scanning light beam into a first scanning light beam and a second scanning light beam. An optical power of the first scanning light beam is greater than or equal to a nonlinear effect power threshold of the optical microcavity (40). The frequency shifter (30) is configured to change a frequency of the second scanning light beam to generate a third scanning light beam whose frequency changes in a second direction. The optical microcavity (40) is configured to generate, when the first scanning light beam is in a red detuning region of the optical microcavity and the third scanning light beam is in a blue detuning region of the optical microcavity, a target light beam whose spectrum is a target optical frequency comb. The provided optical fre-

quency comb generation device (100) can generate an optical frequency comb with a narrow linewidth, and has high applicability and practicability.

FIG. 1

EP 4 475 359 A1

## Description

This application claims priority to Chinese Patent Application No. 202210265993.X, filed with the China National Intellectual Property Administration on March 17, 2022 and entitled "OPTICAL FREQUENCY COMB GENERATION DEVICE AND METHOD, LIGHT EMISSION DEVICE, AND OPTICAL COMMUNICATION SYSTEM", which is incorporated herein by reference in its entirety.

## TECHNICAL FIELD

This application relates to the field of optical technologies, and in particular, to an optical frequency comb generation device and method, a light emission device, and an optical communication system.

## BACKGROUND

With rapid development of optical technologies, an optical frequency comb (optical frequency comb, OFC) has been widely used in the optical field. Currently, most common optical frequency combs are Kerr optical frequency combs (also referred to as microcavity optical frequency combs). The Kerr optical frequency comb is an optical frequency comb generated by a laser in a nonlinear optical microcavity based on a Kerr nonlinear feature in the optical microcavity. Due to a high repetition frequency, a wide frequency band, and an extremely compact generation apparatus, a radius of the optical microcavity on which the Kerr optical frequency comb depends is only at a 100-micrometer level. Therefore, the Kerr optical frequency comb has very important applications in many fields such as laser radar, optical communication, atomic clock, and laser ranging. However, in an actual optical communication (for example, coherent optical communication) scenario, a linewidth of the Kerr optical frequency comb is one of key parameters that affect communication quality. A smaller linewidth of the Kerr optical frequency comb indicates better coherence and monochromaticity of a light source implemented based on the Kerr optical frequency comb, and lower noise. Therefore, how to ensure a narrow linewidth of the Kerr optical frequency comb has become a current research hotspot.

In a conventional technology, a laser is usually used to perform frequency scanning, so that a soliton mode-locked Kerr optical comb is generated in an optical microcavity. Alternatively, a single sideband modulator is used to implement fast frequency scanning of a laser device with an ultra-narrow linewidth, so that a soliton mode-locked Kerr optical comb is generated in an optical microcavity. However, noise (mainly including a random change of an optical frequency comb spacing that is caused by a detuning amount jitter of the laser, an optical frequency comb frequency jitter caused by a frequency jitter of the laser, and an optical frequency comb frequency jitter caused by thermo-refractive noise of the optical microcavity) exists in all these solutions, and linewidths of obtained Kerr optical frequency combs are large. Therefore, how to eliminate noise existing in an optical frequency comb generation process to obtain an optical frequency comb with a narrow linewidth has become one of problems to be urgently resolved.

## SUMMARY

To resolve the foregoing problem, this application provides an optical frequency comb generation device and method, a light emission device, and an optical communication system. The optical frequency comb generation device can reduce or even eliminate noise existing in an optical frequency comb generation process. Therefore, an optical frequency comb with a narrow linewidth can be generated, and applicability and practicability of the optical frequency comb generation device are high.

According to a first aspect, an embodiment of this application provides an optical frequency comb generation device. The device includes a laser device, an optical splitter, a frequency shifter, and an optical microcavity. The laser device is configured to: generate a source scanning light beam whose frequency changes in a first direction, and transmit the source scanning light beam to the optical splitter. The optical splitter is configured to: split the source scanning light beam into a first scanning light beam and a second scanning light beam, transmit the first scanning light beam to the optical microcavity, and transmit the second scanning light beam to the frequency shifter. An optical power of the first scanning light beam is greater than or equal to a nonlinear effect power threshold of the optical microcavity herein. The frequency shifter is configured to: generate, based on the second scanning light beam, a third scanning light beam whose frequency changes in a second direction, and transmit the third scanning light beam to the optical microcavity. The optical microcavity is configured to generate a target light beam when the first scanning light beam is in a red detuning region of the optical microcavity and the third scanning light beam is in a blue detuning region of the optical microcavity. Herein, a spectrum of the target light beam is a target optical frequency comb.

In the foregoing implementation, laser scanning is performed on the optical microcavity by using the first scanning light beam and the third scanning light beam that have a same source, so that three types of noise, to be specific, a random change of an optical frequency comb spacing that is caused by a detuning amount jitter of the first scanning light beam, an optical frequency comb frequency jitter caused by a frequency jitter of the laser device, and an optical frequency comb frequency jitter caused by a resonance frequency jitter, can be reduced or eliminated. In this way, noise that easily generates linewidth enhancement effect in the optical frequency comb generation device can be reduced or even eliminated, and the optical frequency comb generation device can generate the target optical frequency comb with a narrow linewidth. Further, applicability and practicability of the optical frequency comb generation device can be improved.

With reference to the first aspect, in a first optional implementation, the first scanning light beam and the third scanning light beam are transmitted in opposite directions in the optical microcavity.

In the foregoing implementation, the first scanning light beam and the third scanning light beam are transmitted in opposite directions, so that the optical microcavity can be prevented from generating an unnecessary optical frequency comb based on the third scanning light beam while generating the target optical frequency comb based on the first scanning light beam. Therefore, impact of the unnecessary optical frequency comb on the target optical frequency comb is eliminated, and stability and narrow linewidth performance of the target optical frequency comb can be ensured.

With reference to the first aspect or the first optional implementation of the first aspect, in a second optional implementation, a frequency change speed of the third scanning light beam is greater than or equal to a frequency change speed of the first scanning light beam.

In the foregoing implementation, it is ensured that the frequency change speed of the third scanning light beam is greater than or equal to the frequency change speed of the first scanning light beam, so that a probability that nonlinear effect occurs in the optical microcavity can be increased, and a generation frequency of the target optical frequency comb can be increased.

With reference to the first aspect or the first and the second optional implementations of the first aspect, in a third optional implementation, the device further includes a first waveguide and a circulator. A first port of the optical splitter is connected to the laser device, a second port of the optical splitter is connected to a first port of the first waveguide, a second port of the first waveguide is connected to a first port of the circulator, and the optical microcavity is coupled between the first port and the second port of the first waveguide. A third port of the optical splitter is connected to a first port of the frequency shifter, and a second port of the frequency shifter is connected to a second port of the circulator. The first waveguide is configured to transmit the first scanning light beam to the optical microcavity. The first waveguide and the circulator are configured to transmit the third scanning light beam to the optical microcavity. A third port of the circulator is configured to output the target light beam.

In the foregoing implementation, the first waveguide and the circulator are used to input the first scanning light beam and the third scanning light beam to the optical microcavity and output the target light beam from the optical microcavity. This solution is simple and easy to implement, can reduce structural complexity of the optical frequency comb generation device, and can improve reliability of the optical frequency comb generation device.

With reference to the third optional implementation of the first aspect, in a fourth optional implementation, the device further includes a first amplifier and a second amplifier. The second port of the optical splitter is connected to the first port of the first waveguide through the first amplifier, and the first amplifier is configured to: adjust the optical power of the first scanning light beam, and transmit the first scanning light beam obtained after optical power adjustment to the first waveguide. An optical power of the first scanning light beam obtained after the optical power adjustment is greater than or equal to the nonlinear effect power threshold. The third port of the optical splitter is connected to the first port of the frequency shifter through the second amplifier, and the second amplifier is configured to: adjust an optical power of the second scanning light beam, and transmit the second scanning light beam obtained after optical power adjustment to the frequency shifter.

In the foregoing implementation, the first amplifier and the second amplifier are added to the optical frequency comb generation device, so that adjustment of optical powers of the first scanning light beam and the second scanning light beam can be facilitated, and function flexibility of the optical frequency comb generation device is improved.

With reference to the fourth optional implementation of the first aspect, in a fifth optional implementation, the device further includes a first filter and a second filter. The first amplifier is connected to the first port of the first waveguide through the first filter, and the first filter is configured to: perform noise filtering on the first scanning light beam, and transmit the first scanning light beam obtained after the noise filtering to the first waveguide. The second amplifier is connected to the frequency shifter through the second filter, and the second filter is configured to: perform noise filtering on the second scanning light beam, and transmit the second scanning light beam obtained after the noise filtering to the frequency shifter.

In the foregoing implementation, the first filter and the second filter are added to the optical frequency comb generation device, so that noise carried by the first scanning light beam and the second scanning light beam can be filtered out through the two components. In this way, generation efficiency of the target optical frequency comb can be improved, and stability of the target optical frequency comb can be ensured.

With reference to the fifth optional implementation of the first aspect, in a sixth optional implementation, the device further includes a first polarization controller and a second polarization controller. The first filter is connected to the first port of the first waveguide through the first polarization controller. The first polarization controller is configured to: adjust a polarization state of the first scanning light beam to a target polarization state corresponding to the optical microcavity, and transmit the first scanning light beam obtained after polarization state adjustment to the first waveguide. The frequency shifter is connected to the second port of the circulator through the second polarization controller. The second polarization controller is configured to: adjust a polarization state of the third scanning light beam to the target polarization state, and transmit the third scanning light beam obtained after polarization state adjustment to the circulator.

In the foregoing implementation, the first polarization controller and the second polarization controller are added to the optical frequency comb generation device, so that polarization states of the first scanning light beam and the third scanning light beam that enter the optical microcavity can be adjusted through the two components. In this way, the polarization states of the first scanning light beam and the third scanning light beam are consistent with the target polarization state of the optical microcavity. In an aspect, this can improve optical conversion efficiency of the optical microcavity, and further improve the generation efficiency of the target optical frequency comb. In another aspect, other elements in the device may also use non-polarization-maintaining optical components, so that costs of the optical frequency comb generation device can be reduced.

With reference to the third to the sixth optional implementations of the first aspect, in a seventh optional implementation, the device further includes a detector and a controller. The detector is connected to the third port of the circulator, and the controller is connected to the laser device, the frequency shifter, and the detector. The detector is configured to detect a light beam output by the third port of the circulator. When the light beam output by the third port of the circulator is the target light beam, the controller is configured to: control the laser device to stop a change of the frequency of the source scanning light beam, and control the frequency shifter to stop a change of the frequency of the third scanning light beam.

With reference to the seventh optional implementation of the first aspect, in an eighth optional implementation, after the light beam output by the third port of the circulator is the target light beam, when an optical power of the light beam output by the third port of the circulator changes, the controller is further configured to control the frequency shifter to change the frequency of the third scanning light beam until the optical power of the light beam output by the third port of the circulator is restored to an optical power of the target light beam.

In the foregoing implementation, when the optical power of the light beam output by the third port of the circulator changes (in other words, the optical power of the light beam is no longer the optical power of the target light beam), the controller may be used to control the frequency shifter to change the frequency of the third scanning light beam, to enable the optical power of the light beam output by the third port of the circulator to be restored to the optical power of the target light beam. In this way, it can be ensured that the optical frequency comb generation device can continuously and stably output the target optical frequency comb.

With reference to the first aspect or the first and the second optional implementations of the first aspect, in a ninth optional implementation, the device further includes a second waveguide and a third waveguide. A first port of the optical splitter is connected to the laser device, a second port of the optical splitter is connected to a first port of the second waveguide, and the optical microcavity is coupled between the first port and a second port of the second waveguide. A third port of the optical splitter is connected to a first port of the frequency shifter, a second port of the frequency shifter is connected to a first port of the third waveguide, and the optical microcavity is coupled between the first port and a second port of the third waveguide. The second waveguide is configured to transmit the first scanning light beam to the optical microcavity, the third waveguide is configured to transmit the third scanning light beam to the optical microcavity, and the second port of the second waveguide is configured to output the target light beam.

In the foregoing implementation, the second waveguide and the third waveguide are used to input the first scanning light beam and the third scanning light beam to the optical microcavity and output the target light beam from the optical microcavity. This solution is simple and has low costs, and can reduce costs of the optical frequency comb generation device while reducing structural complexity of the optical frequency comb generation device.

With reference to the ninth optional implementation of the first aspect, in a tenth optional implementation, the device further includes a first amplifier and a second amplifier. The second port of the optical splitter is connected to the first port of the second waveguide through the first amplifier, and the first amplifier is configured to: adjust the optical power of the first scanning light beam, and transmit the first scanning light beam obtained after optical power adjustment to the second waveguide. Herein, an optical power of the first scanning light beam obtained after the optical power adjustment is greater than or equal to the nonlinear effect power threshold. The third port of the optical splitter is connected to the first port of the frequency shifter through the second amplifier, and the second amplifier is configured to: adjust an optical power of the second scanning light beam, and transmit the second scanning light beam obtained after optical power adjustment to the frequency shifter.

In the foregoing implementation, the first amplifier and the second amplifier are added to the optical frequency comb generation device, so that adjustment of optical powers of the first scanning light beam and the second scanning light beam can be facilitated, and function flexibility of the optical frequency comb generation device is improved.

With reference to the tenth optional implementation of the first aspect, in an eleventh optional implementation, the device further includes a first filter and a second filter. The first amplifier is connected to the second waveguide through the first filter, and the first filter is configured to: perform noise filtering on the first scanning light beam, and transmit the first scanning light beam obtained after the noise filtering to the second waveguide. The second amplifier is connected to the first port of the frequency shifter through the second filter, and the second filter is configured to: perform noise filtering on the second scanning light beam, and transmit the second scanning light beam obtained after the noise filtering to the frequency shifter.

In the foregoing implementation, the first filter and the second filter are added to the optical frequency comb generation device, so that noise introduced by the first scanning light beam and the second scanning light beam due to power adjustment can be filtered out through the two components. In this way, generation efficiency of the target optical frequency comb can be improved, and stability of the target optical frequency comb can be ensured.

With reference to the eleventh optional implementation of the first aspect, in a twelfth optional implementation, the device further includes a first polarization controller and a second polarization controller. The first filter is connected to the first port of the second waveguide through the first polarization controller, and the first polarization controller is configured to: adjust a polarization state of the first scanning light beam to a target polarization state of the optical microcavity, and transmit the first scanning light beam obtained after polarization state adjustment to the second waveguide. The frequency shifter is connected to the first port of the third waveguide through the second polarization controller, and the second polarization controller is configured to: adjust a polarization state of the third scanning light beam to the target polarization state, and transmit the third scanning light beam obtained after polarization state adjustment to the third waveguide.

In the foregoing implementation, the first polarization controller and the second polarization controller are added to the optical frequency comb generation device, so that polarization states of the first scanning light beam and the third scanning light beam can be enabled to be consistent with the target polarization state of the optical microcavity through the two components. In an aspect, this can improve optical conversion efficiency of the optical microcavity, and further improve the generation efficiency of the target optical frequency comb. In another aspect, other elements in the device may also use non-polarization-maintaining optical components, so that the costs of the optical frequency comb generation device can be reduced.

With reference to the ninth to the twelfth optional implementations of the first aspect, in a thirteenth optional implementation, the device further includes a detector and a controller. The detector is connected to the second port of the second waveguide, and the controller is connected to the laser device, the frequency shifter, and the detector. The detector is configured to detect a light beam output by the second port of the third waveguide. When the light beam output by the second port of the third waveguide is the target light beam, the controller is configured to: control the laser device to stop a change of the frequency of the source scanning light beam, and control the frequency shifter to stop a change of the frequency of the third scanning light beam.

With reference to the thirteenth optional implementation of the first aspect, in a fourteenth optional implementation, after the light beam output by the second port of the third waveguide is the target light beam, when an optical power of a light beam output by the second port of the second waveguide changes, the controller is further configured to control the frequency shifter to change the frequency of the third scanning light beam until the optical power of the light beam output by the second port of the second waveguide is equal to an optical power of the target light beam.

In the foregoing implementation, when the optical power of the light beam output by the second port of the second waveguide changes, the controller may be used to control the frequency shifter to change the frequency of the third scanning light beam, to enable the optical power of the light beam output by the second port of the second waveguide to be restored to the optical power of the target light beam. In this way, it can be ensured that the optical frequency comb generation device can continuously and stably output the target optical frequency comb.

With reference to the first aspect or the first to the fourteenth optional implementations of the first aspect, in a fifteenth optional implementation, the laser device is a sub-hertz linewidth laser device.

According to a second aspect, an embodiment of this application provides an optical frequency comb generation method. The method is applicable to the optical frequency comb generation device according to the first aspect. The device includes a laser device, an optical splitter, a frequency shifter, and an optical microcavity. The method includes: generating, through the laser device, a source scanning light beam whose frequency changes in a first direction, and transmitting the source scanning light beam to the optical splitter; splitting, through the optical splitter, the source scanning light beam into a first scanning light beam and a second scanning light beam, transmitting the first scanning light beam to the optical microcavity, and transmitting the second scanning light beam to the frequency shifter, where an optical power of the first scanning light beam is greater than or equal to a nonlinear effect power threshold of the optical microcavity herein; generating, through the frequency shifter based on the second scanning light beam, a third scanning light beam whose frequency changes in a second direction, and sending the third scanning light beam to the optical microcavity; and generating, through the optical microcavity, a target light beam when the first scanning light beam is in a red detuning region of the optical microcavity and the third scanning light beam is in a blue detuning region of the optical microcavity, where a spectrum of the target light beam is a target optical frequency comb.

With reference to the second aspect, in a first optional implementation, the first scanning light beam and the third scanning light beam are transmitted in opposite directions in the optical microcavity.

With reference to the second aspect or the first optional implementation of the second aspect, in a second optional implementation, a frequency change speed of the third scanning light beam is greater than or equal to a frequency change speed of the first scanning light beam.

With reference to the second aspect or the first and the second optional implementations of the second aspect, in a third optional implementation, the device further includes a first waveguide and a circulator. The first scanning light beam may be transmitted to the optical microcavity through the first waveguide. The third scanning light beam may be further sent to the optical microcavity through the first waveguide and the circulator.

With reference to the third optional implementation of the second aspect, in a fourth optional implementation, the device further includes a detector and a controller. A light beam output by a third port of the circulator may be detected through the detector. When it is determined that the light beam output by the third port of the circulator is the target light beam, the laser device is further controlled, through the controller, to stop a change of the frequency of the source scanning light beam, and the frequency shifter is controlled to stop a change of the frequency of the third scanning light beam.

With reference to the fourth optional implementation of the second aspect, in a fifth optional implementation, after it is determined that the light beam output by the third port of the circulator is the target light beam, when it is determined that an optical power of the light beam output by the third port of the circulator changes, the frequency shifter may be controlled, through the controller, to change the frequency of the third scanning light beam until the optical power of the light beam output by the third port of the circulator is restored to an optical power of the target light beam.

With reference to the second aspect or the first and the second optional implementations of the second aspect, in a sixth optional implementation, the device further includes a second waveguide and a third waveguide. The first scanning light beam may be transmitted to the optical microcavity through the second waveguide. The third scanning light beam may be further transmitted to the optical microcavity through the third waveguide.

With reference to the sixth optional implementation of the second aspect, in a seventh optional implementation, the device further includes a detector and a controller. The detector is connected to a second port of the second waveguide, and the controller is connected to the laser device, the frequency shifter, and the detector. A light beam output by the second port of the second waveguide may be detected through the detector. When it is determined that the light beam output by the second port of the second waveguide is the target light beam, the laser device is further controlled, through the controller, to stop a change of the frequency of the source scanning light beam, and the frequency shifter is controlled to stop a change of the frequency of the third scanning light beam.

With reference to the seventh optional implementation of the second aspect, in an eighth optional implementation, after it is determined that the light beam output by the second port of the second waveguide is the target light beam, when it is determined that an optical power of the light beam output by the second port of the second waveguide changes, the frequency shifter is further controlled, through the controller, to change the frequency of the third scanning light beam until the optical power of the light beam output by the second port of the second waveguide is restored to an optical power of the target light beam.

With reference to the third to the eighth optional implementations of the second aspect, in a ninth optional implementation, the device further includes a first amplifier and a second amplifier. The optical power of the first scanning light beam may be adjusted through the first amplifier. An optical power of the first scanning light beam obtained after optical power adjustment is greater than or equal to the nonlinear effect power threshold. An optical power of the second scanning light beam may be adjusted through the second amplifier.

With reference to the ninth optional implementation of the second aspect, in a tenth optional implementation, the device further includes a first filter and a second filter. Noise filtering may be performed, through the first filter, on the first scanning light beam obtained after the optical power adjustment. Noise filtering may be performed, through the second filter, on the second scanning light beam obtained after optical power adjustment.

With reference to the tenth optional implementation of the second aspect, in an eleventh optional implementation, the device further includes a first polarization controller and a second polarization controller. A polarization state of the first scanning light beam obtained after the noise filtering may be adjusted to a target polarization state of the optical microcavity through the first polarization controller. A polarization state of the third scanning light beam may be further adjusted to the target polarization state through the second polarization controller.

With reference to the second aspect or the first to the eleventh optional implementations of the second aspect, in a twelfth optional implementation, the laser device is a sub-hertz linewidth laser device.

According to a third aspect, an embodiment of this application provides a light emission device. The light emission device includes the optical frequency comb generation device according to any implementation of the first aspect and an optical signal processor. The optical frequency comb generation device and the optical signal processor are connected to each other. The optical frequency comb generation device is configured to generate a target light beam. Herein, a spectrum of the target light beam is a target optical frequency comb. The optical signal processor is configured to modulate the target light beam and output target signal light.

With reference to the third aspect, in an optional implementation, the optical frequency comb generation device may be specifically an optical transmitter or an optical receiver in a coherent optical communication system, or may be an integrated light source in a laser radar.

According to a fourth aspect, an embodiment of this application provides an optical communication system. The optical communication system includes the light emission device according to any implementation of the first aspect and a light reception device. The light emission device is connected to the light reception device. The light emission device is configured to generate target signal light based on a target light beam and transmit the target signal light to the light reception device.

The solutions provided in the second aspect to the fourth aspect are used to implement or cooperate to implement the optical frequency comb generation apparatus provided in any implementation of the first aspect. Therefore, the solutions can achieve same or corresponding beneficial effect as the first aspect. Details are not described herein again.

In conclusion, according to the optical frequency comb generation device and method provided in embodiments of this application, noise existing in an optical frequency comb generation process can be effectively reduced or even eliminated, and an optical frequency comb with a narrow linewidth can be obtained.

## BRIEF DESCRIPTION OF DRAWINGS

FIG. 1 is a schematic diagram of a structure of an optical frequency comb generation device according to an embodiment of this application;

FIG. 2 is a schematic diagram of descriptions of red detuning and blue detuning according to an embodiment of this application;

FIG. 3 is a schematic diagram of another structure of an optical frequency comb generation device according to an embodiment of this application;

FIG. 4 is a schematic diagram of another structure of an optical frequency comb generation device according to an embodiment of this application;

FIG. 5 is a schematic diagram of another structure of an optical frequency comb generation device according to an embodiment of this application;

FIG. 6 is a schematic diagram of another structure of an optical frequency comb generation device according to an embodiment of this application;

FIG. 7 is a schematic diagram of another structure of an optical frequency comb generation device according to an embodiment of this application;

FIG. 8 is a schematic diagram of another structure of an optical frequency comb generation device according to an embodiment of this application;

FIG. 9 is a schematic diagram of another structure of an optical frequency comb generation device according to an embodiment of this application;

FIG. 10 is a schematic diagram of another structure of an optical frequency comb generation device according to an embodiment of this application;

FIG. 11 is a schematic diagram of another structure of an optical frequency comb generation device according to an embodiment of this application;

FIG. 12 is a schematic diagram of another structure of an optical frequency comb generation device according to an embodiment of this application;

FIG. 13 is a schematic diagram of another structure of an optical frequency comb generation device according to an embodiment of this application;

FIG. 14 is a schematic diagram of another structure of an optical frequency comb generation device according to an embodiment of this application;

FIG. 15 is a schematic flowchart of an optical frequency comb generation method according to an embodiment of this application;

FIG. 16 is a schematic diagram of a structure of a light emission device according to an embodiment of this application; and

FIG. 17 is a schematic diagram of a structure of an optical communication system according to an embodiment of this application.

## DESCRIPTION OF EMBODIMENTS

The following clearly and completely describes technical solutions in embodiments of this application with reference to accompanying drawings in embodiments of this application.

In a conventional technology, a laser is usually used to perform frequency scanning, so that a soliton mode-locked Kerr optical comb is generated in an optical microcavity. Alternatively, a single sideband modulator is used to implement fast frequency scanning of a laser device with an ultra-narrow linewidth, so that a soliton mode-locked Kerr optical comb is generated in an optical microcavity. However, none of these solutions can overcome noise including a random change of an optical frequency comb spacing that is caused by a detuning amount jitter of the laser, an optical frequency comb frequency jitter caused by an amplitude jitter of the laser, and an optical frequency comb frequency jitter caused by thermo-refractive noise of the optical microcavity. Consequently, an optical frequency comb with a narrow linewidth cannot be obtained.

Therefore, a technical problem to be resolved in this application is how to eliminate noise existing in an optical frequency comb generation process, to obtain an optical frequency comb with a narrow linewidth.

## Embodiment 1

To resolve the foregoing problem, this application provides an optical frequency comb generation device. In the optical frequency comb generation device, two light beams with a same source simultaneously enter an optical microcavity and are used to perform frequency scanning on the optical microcavity. When one light beam is in a red detuning region of the optical microcavity and the other light beam is in a blue detuning region of the optical microcavity, a target light beam whose spectrum is a target optical frequency comb can be generated. In this process, introduction of the two light beams with the same source may cancel noise existing in an optical frequency comb generation process, so that the noise in the optical frequency comb generation process can be reduced or eliminated. Therefore, the optical frequency comb generation device can generate an optical frequency comb with a narrow linewidth.

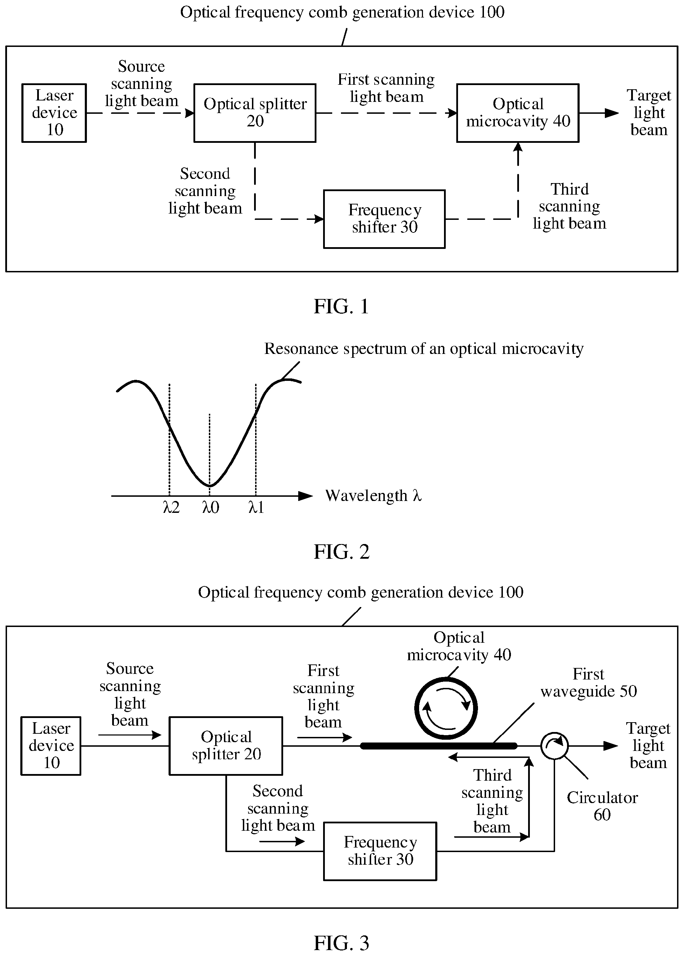

With reference to FIG. 1 to FIG. 14, the following describes in detail structures and working principles of the optical frequency comb generation device provided in this application.

FIG. 1 is a schematic diagram of a structure of the optical frequency comb generation device according to an embodiment of this application. As shown in FIG. 1, the optical frequency comb generation device 100 may include a laser device 10, an optical splitter 20, a frequency shifter 30, and an optical microcavity 40. The laser device 10 is connected to the optical splitter 20, the optical splitter 20 is further connected to the frequency shifter 30 and the optical microcavity 40, and the frequency shifter 30 is further connected to the optical microcavity 40.

During actual work, the laser device 10 may be configured to: generate a light beam (for ease of differentiation, a source scanning light beam is used as a substitute for description below) whose frequency changes in a first direction, and transmit the source scanning light beam to the optical splitter 20. It may also be understood as that the laser device 10 is configured to perform frequency scanning by using a first scanning light beam. It should be understood that, that the frequency changes in the first direction means that the frequency of the source scanning light beam gradually changes in ascending order (in other words, the first direction is the ascending order), or gradually changes in descending order (in other words, the first direction is the descending order). In addition, a change of the source scanning light beam in the first direction may be an equal change, or may be a non-equal change. This is not specifically limited in this application. The optical splitter 20 may be configured to: split the source scanning light beam to obtain two light beams (for ease of differentiation, the first scanning light beam and a second scanning light beam are used as substitutes for description below), transmit the first scanning light beam to the optical microcavity 40, and transmit the second scanning light beam to the frequency shifter 30. An optical power of the first scanning light beam is greater than or equal to a nonlinear effect power threshold of the optical microcavity 40. It should be understood that the optical splitter 20 may perform optical splitting by using any optical splitting ratio, to obtain the first scanning light beam and the second scanning light beam. The optical splitting ratio of the optical splitter 20 is not specifically limited in this application. It should be further noted herein that a nonlinear effect power threshold of any microcavity is one of necessary conditions that need to be met to stimulate nonlinear effect of the microcavity. The nonlinear effect of the microcavity may be stimulated only when a power of light entering the microcavity is greater than or equal to the nonlinear effect power threshold. During actual application, microcavities of different structures may have different nonlinear effect power thresholds. Therefore, a value of the nonlinear effect threshold of the optical microcavity 40 may be determined by a structure of the optical microcavity 40. This is not specifically limited in this application. The frequency shifter 30 may be configured to: change a frequency of the second scanning light beam to generate a scanning light beam (for ease of differentiation, a third scanning light beam is used as a substitute for description below) whose frequency changes in a second direction, and transmit the third scanning light beam to the optical microcavity 40. Similarly, it may also be understood as that the frequency shifter 30 performs frequency scanning by using the third scanning light beam. Herein, the second direction may be opposite to or the same as the first direction described above, and may be specifically determined based on an actual design requirement. This is not limited in this application. In addition, when entering the optical microcavity 40, the first scanning light beam and the third scanning light beam have different frequencies. Optionally, a frequency change speed of the third scanning light beam needs to be greater than or equal to a frequency change speed of the first scanning light beam (or the second scanning light beam). In other words, a frequency scanning speed of the frequency shifter 30 needs to be greater than or equal to a frequency scanning speed of the laser device 10. For example, during actual implementation, the laser device 10 may be enabled to perform frequency scanning at a normal speed, and the frequency shifter 30 may be enabled to perform fast frequency scanning. Herein, it is ensured that the frequency change speed of the third scanning light beam is greater than or equal to the frequency change speed of the first scanning light beam, so that a probability that nonlinear effect occurs in the optical microcavity 40 (in other words, the optical microcavity 40 enters a single dissipative soliton state) can be increased, and therefore a generation speed of a target optical frequency comb can be increased.

To facilitate understanding of functions of the laser device 10, the optical splitter 20, and the frequency shifter 30, the following describes working principles of the laser device 10, the optical splitter 20, and the frequency shifter 30 by using examples. It is assumed that the first direction is the ascending order, and the second direction is the descending order. At a moment t0, the laser device 10 may generate and output a source scanning light beam L00 whose frequency is f0. The optical splitter 20 may split the source scanning light beam L00 into a first scanning light beam L10 whose frequency is f0 and a second scanning light beam L20 whose frequency is f0, transmit the first scanning light beam L10 to the optical microcavity 20, and transmit the second scanning light beam L20 to the frequency shifter 30. After receiving the second scanning light beam L20, the frequency shifter 30 may perform frequency shifting on the second scanning light beam L20 based on a second control signal S20 received by the frequency shifter 30 to obtain a third scanning light beam L30 whose frequency is f30. Then, at a moment t1 after the moment t0, the laser device 10 may generate a source scanning light beam L01 whose frequency is f1, and transmit the source scanning light beam L01 to the optical splitter 20. Herein, the frequency f1 is greater than the frequency f0. The optical splitter 20 may split the source scanning light beam L01 into a first scanning light beam L11 whose frequency is f1 and a second scanning light beam L21 whose frequency is f1, transmit the first scanning light beam L11 to the optical microcavity 40, and transmit the second scanning light beam L21 to the frequency shifter 30. After receiving the second scanning light beam L21, the frequency shifter 30 may perform frequency shifting on the second scanning light beam to obtain a third scanning light beam L31 whose frequency is f31, where the frequency f30 is less than the frequency f31. Further, at a moment t2 after the moment t1, the laser device 10 may generate a source scanning light beam L02 whose frequency is f2, and transmit the source scanning light beam L02 to the optical splitter 20. Herein, the frequency f2 is greater than the frequency f1. The optical splitter 20 may split the source scanning light beam L02 into a first scanning light beam L12 whose frequency is f2 and a second scanning light beam L22 whose frequency is f2, transmit the first scanning light beam L12 to the optical microcavity 40, and transmit the second scanning light beam L22 to the frequency shifter 30. After receiving the second scanning light beam L22, the frequency shifter 30 may perform frequency shifting on the second scanning light beam to obtain a third scanning light beam L32 whose frequency is f32, where the frequency f32 is less than the frequency f31. By analogy, under action of the laser device 10 and the frequency shifter 30, a frequency of the first scanning light beam gradually increases, and the frequency of the third scanning light beam gradually decreases.

Further, the optical microcavity 40 may continuously receive the first scanning light beam and the third scanning light beam. As time elapses, input of the third scanning light beam causes continuous energy accumulation in the optical microcavity 40, and therefore form a heat source. The heat source may enable a resonance line of the optical microcavity 40 to move toward a long wave (in other words, enable a resonance wavelength of the optical microcavity 40 to change). However, when the resonance wavelength of the optical microcavity 40 changes, the frequencies of the first scanning light beam and the third scanning light beam also continuously change. Finally, the first scanning light beam enters a red detuning region of the optical microcavity 40, and the third scanning light beam enters a blue detuning region of the optical microcavity 40. It should be noted herein that red detuning of a microcavity means that a wavelength of an incident light beam is greater than a resonance wavelength of the microcavity, and blue detuning of a microcavity means that a wavelength of an incident light beam is less than a resonance wavelength of the microcavity. For example, the first scanning light beam and the third scanning light beam are used as an example. FIG. 2 is a schematic diagram of descriptions of red detuning and blue detuning according to an embodiment of this application. FIG. 2 shows a location relationship between wavelengths of the first scanning light beam and the third scanning light beam and a resonance spectrum of the optical microcavity 40 at a specific moment (assumed as T herein) in a process of generating the target optical frequency comb. As shown in FIG. 2, at the moment T, a wavelength $\lambda 0$ corresponding to a wave trough of the resonance spectrum of the optical microcavity 40 is the resonance wavelength of the optical microcavity 40. In this case, a wavelength of the first scanning light beam is $\lambda 1$, and is greater than the resonance wavelength $\lambda 0$ of the optical microcavity 40, so that the first scanning light beam is in a red detuning resonance mode of the optical microcavity 40. In addition, in this case, a wavelength of the third scanning light beam is $\lambda 2$, and is less than the resonance wavelength $\lambda 0$ of the optical microcavity 40, so that the third scanning light beam is in a blue detuning resonance mode of the optical microcavity 40. When the first scanning light beam is in the red detuning region of the optical microcavity 40 and the third scanning light beam is in the blue detuning region of the optical microcavity 40, the nonlinear effect of the optical microcavity 40 may be stimulated, and therefore a corresponding dissipative soliton mode-locked Kerr optical frequency comb is generated. In short, when the first scanning light beam is in the red detuning region of the optical microcavity 40 and the third scanning light beam is in the blue detuning region of the optical microcavity 40, the optical microcavity 40 may generate and output a light beam (for ease of differentiation, a target light beam is used as a substitute for description below) whose spectrum is the target optical frequency comb (that is, an optical frequency comb with a narrow linewidth).

Optionally, the first scanning light beam and the third scanning light beam are transmitted in opposite directions in the optical microcavity 40. For example, when the first scanning light beam is transmitted in the optical microcavity 40 in a clockwise direction, the third scanning light beam is transmitted in the optical microcavity 40 in an anti-clockwise direction. When the first scanning light beam is transmitted in the optical microcavity 40 in an anti-clockwise direction, the third scanning light beam is transmitted in the optical microcavity 40 in a clockwise direction. Herein, the first scanning light beam and the third scanning light beam are transmitted in opposite directions, so that the optical microcavity 40 can be prevented from generating an unnecessary optical frequency comb based on the third scanning light beam while generating the target optical frequency comb based on the first scanning light beam. Therefore, impact of the unnecessary optical frequency comb on the target optical frequency comb is eliminated, and stability and narrow linewidth performance of the target optical frequency comb can be ensured.

With reference to a generation mechanism of noise in an optical frequency comb generation process and a nonlinear effect principle of the optical microcavity 40, the following explains and describes in detail a principle that the optical frequency comb generation device 100 can reduce or even eliminate the noise. Herein, it is assumed that a specific detuning amount of the third scanning light beam is $\delta_A$, a specific detuning amount of the first scanning light beam is $\delta_P$, a frequency shift amount of the frequency shifter 30 is $f_{AOM}$, and a resonance frequency of the optical microcavity 40 is $v_C$. Herein, the frequency shift amount of the frequency shifter 30 is a magnitude of a frequency that can be changed by the frequency shifter each time, and the frequency shift amount $f_{AOM}$ is usually a fixed value. During actual implementation, the detuning amount $\delta_A$ is usually affected by a frequency jitter $v_A$ of the third scanning light beam, a microcavity resonance mode thermal jitter $v_T$ of the optical microcavity 40, a self-phase modulation $v_{(SPM,A)}$ of the third scanning light beam, and a cross-phase modulation $v_{(XPM,P)}$ of the first scanning light beam, and the detuning amount $\delta_P$ is usually affected by a frequency jitter $v_P$ of the first scanning light beam, the microcavity resonance mode thermal jitter $v_T$ of the optical microcavity 40, a self-phase modulation $v_{(SPM,P)}$ of the first scanning light beam, and a cross-phase modulation $v_{(XPM,A)}$ of the third scanning light beam. Herein, because the frequencies of the first scanning light beam and the third scanning light beam always change in a frequency scanning process, the frequency jitter of the scanning light beam herein is a frequency of the scanning light beam at a specific moment. For example, it is assumed that a frequency of the first scanning light beam at a moment t4 is f4. In this case, a frequency jitter of the first scanning light beam at the moment t4 is f4. The microcavity resonance mode thermal jitter $v_T$ is a change amount of the resonance frequency that is caused by a temperature change of the optical microcavity 40. The self-phase modulation $v_{(SPM,P)}$ of the first scanning light beam is essentially a frequency change amount of the first scanning light beam that is caused by self-phase modulation of the first scanning light beam. Similarly, the self-phase modulation $v_{(SPM,A)}$ of the third scanning light beam is a frequency change amount of the third scanning light beam that is caused by self-phase modulation of the third scanning light beam. The cross-phase modulation $v_{(XPM,A)}$ of the third scanning light beam is essentially a frequency change amount of the first scanning light beam that is caused by cross-phase modulation of the first scanning light beam and the third scanning light beam. Similarly, the cross-phase modulation $v_{(XPM,P)}$ of the first scanning light beam is a frequency change amount of the third scanning light beam that is caused by cross-phase modulation of the third scanning light beam and the first scanning light beam. With reference to the foregoing content, it can be learned that the detuning amount $\delta_A$ may satisfy the following formula (1):

$$\delta_A = (v_A - v_c) - v_T - v_{(SPM,A)} - v_{(XPM,P)} \quad (1)$$

The detuning amount $\delta_P$ may satisfy the following formula (2):

$$\delta_P = (v_P - v_c) - v_T - v_{(SPM,P)} - v_{(XPM,A)} \quad (2)$$

In addition, in the foregoing implementation, because the first scanning light beam and the third scanning light beam are beams with a same source, the specific detuning amount $\delta_A$ of the first scanning light beam and the specific detuning amount $\delta_P$ of the third scanning light beam need to satisfy the following formula (3):

$$\delta_P = \delta_A - f_{AOM} + v_{NL} \quad (3)$$

$v_{NL}$ is a detuning amount difference between the first scanning light beam and the third scanning light beam that is caused by nonlinear phase shifting. A value of $v_{NL}$ is associated with actual powers of the first scanning light beam and the third scanning light beam in the optical microcavity 40, and may satisfy the following formula (4):

$$v_{NL} = (v_{(SPM,A)} - v_{(SPM,P)}) + (v_{(XPM,A)} - v_{(XPM,P)}) \quad (4)$$

With reference to the formula (3), it can be learned that in an actual working process, a detuning amount jitter (assumed as $\Delta\delta_P$ herein) of the first scanning light beam is mainly determined by a detuning amount jitter (assumed as $\Delta\delta_A$

herein) of the third scanning light beam and a jitter (assumed as $\Delta v_{NL}$ herein) of the detuning amount difference $v_{NL}$ between the first scanning light beam and the third scanning light beam that is caused by the nonlinear phase shifting. Therefore, the detuning amount jitter $\Delta\delta_P$ of the first scanning light beam needs to satisfy the following formula (5):

$$\Delta\delta_P = \Delta\delta_A - f_{AOM} + \Delta v_{NL} \ \ (5)$$

It can be learned from a nonlinear phase shift theory of an optical microcavity that when $\Delta\delta_A$ decreases, an optical power of the third scanning light beam in the optical microcavity 40 increases, and the optical power of the first scanning light beam decreases. It can be further learned with reference to the formula (4) that this causes an increase of $\Delta v_{NL}$. On the contrary, when $\Delta\delta_A$ increases, the optical power of the third scanning light beam in the optical microcavity 40 decreases, and the optical power of the first scanning light beam increases. This causes a decrease of $\Delta v_{NL}$. Therefore, a conclusion may be drawn: Values of $\Delta\delta_A$ and $\Delta v_{NL}$ change reversely. To be specific, if $\Delta\delta_A$ increases, $\Delta v_{NL}$ decreases; or if $\Delta\delta_A$ decreases, $\Delta v_{NL}$ increases. It can be learned from this conclusion and content of the formula (5) that, in the optical frequency comb generation device 100 described above, because $\Delta\delta_A$ and $\Delta v_{NL}$ that have decisive effect on the detuning amount jitter $\Delta\delta_P$ of the first scanning light beam are canceled by each other, and the frequency shift amount $f_{AOM}$ is usually a fixed value, when optical powers and initial frequencies of the first scanning light beam and the third scanning light beam are properly set, a value of $\Delta\delta_P$ may be very small or zero. In this way, the optical frequency comb generation device 100 provided in this application can reduce or even eliminate the detuning amount jitter of the first scanning light beam, and can further reduce or eliminate noise of a random change of an optical frequency comb spacing that is caused by the detuning amount jitter of the first scanning light beam, to ensure the narrow linewidth performance of the target optical frequency comb.

Further, it can be learned from the foregoing content that, during actual work, the laser device 10 only needs to perform frequency scanning at the normal speed, and does not need to perform fast scanning. Therefore, in the optical frequency comb generation device 100 described above, there is very small or no noise of an optical frequency comb frequency jitter caused by a frequency jitter of the laser device 10. In addition, it can be learned from the formula (1) and the formula (2) that thermo-refractive noise (thermo-refractive noise, TRN) of the optical microcavity 40 mainly causes a jitter of the resonance frequency $v_C$ of the optical microcavity 40. However, in the optical frequency comb generation device 100 described above, the first scanning light beam and the third scanning light beam have the same source, and the blue-detuned third scanning light beam and the red-detuned first scanning light beam generally enable the optical microcavity 40 to be in a self-thermal-locked state, so that the jitter of the resonance frequency $v_C$ that is caused by the thermo-refractive noise and the microcavity resonance mode thermal jitter $v_T$ of the optical microcavity 40 are canceled by each other (that is, microcavity mode laser cooling effect). Therefore, there is very small or no optical frequency comb frequency jitter caused by the jitter of the resonance frequency $v_C$.

Therefore, it can be learned from the foregoing content that, in the optical frequency comb generation device 100, with the benefit of introduction of the third scanning light beam that has the same source as the first scanning light beam, three types of noise, to be specific, the random change of the optical frequency comb spacing that is caused by the detuning amount jitter of the first scanning light beam, the optical frequency comb frequency jitter caused by the frequency jitter of the laser device 10, and the optical frequency comb frequency jitter caused by the jitter of the resonance frequency $v_C$, can be reduced or eliminated. In this way, noise that easily generates linewidth enhancement effect in the optical frequency comb generation device 100 provided in this application is reduced or even eliminated, and the optical frequency comb generation device 100 can generate the target optical frequency comb with a very narrow linewidth. Therefore, practicability of the optical frequency comb generation device 100 is high.

It should be additionally noted that, during actual implementation, the laser device 10 is a tunable laser device. The optical splitter 20 is a passive optical component that has an optical splitting function and that is in various forms. A form of the optical splitter 20 is not specifically limited in this application. The frequency shifter 30 may be an optical component that has a high-precision frequency shift feature and that is in any form, for example, an acoustic-optic frequency shifter. The optical microcavity 40 may be specifically a Kerr nonlinear component, a microring, a microdisk, or the like.

In some feasible implementations, FIG. 3 is a schematic diagram of another structure of the optical frequency comb generation device according to an embodiment of this application. It should be understood that in FIG. 3, the optical microcavity 40 is shown in a form of a microring. As shown in FIG. 3, the optical frequency comb generation device 100 may further include a first waveguide 50 and a circulator 60. During actual implementation, a first port of the optical splitter 20 is connected to the laser device 10 (in other words, connected to an output port of the laser device 10), a second port of the optical splitter 20 is connected to a first port of the first waveguide 50, and a second port of the first waveguide 50 is connected to a first port of the circulator 60. Preferably, the first waveguide 50 is a straight waveguide. The optical microcavity 40 is coupled between the first port and the second port of the first waveguide 50. In other words, the optical microcavity 40 is disposed at a location close to the first waveguide 50. The optical microcavity 40 and the first waveguide 50 are close to each other but are not in contact with each other, and there is a specific distance between the optical microcavity 40 and the first waveguide 50. A third port of the optical splitter 20 is connected to a first port of the frequency shifter 30, and a second port of the frequency shifter 30 is connected to a second port of the circulator 60. A third port of the circulator 60 may be used as an output port of the optical frequency comb generation device 100, and is configured to output a light beam output by the optical microcavity 40.

During actual work, the first waveguide 50 is configured to transmit the first scanning light beam to the optical microcavity 40, and the first waveguide 50 and the circulator 60 are configured to transmit the third scanning light beam to the optical microcavity 40. When the optical microcavity 40 outputs the target light beam, the third port of the circulator 60 is configured to output the target light beam. Specifically, the optical splitter 20 may transmit the first scanning light beam to the first waveguide 50 through the second port of the optical splitter 20. The first waveguide 50 may receive the first scanning light beam through the first port of the first waveguide 50. In a process in which the first scanning light beam is transmitted from the first port to the second port of the first waveguide 50, when the first scanning light beam passes through a location that is of the first waveguide 50 and that is close to the optical microcavity 40, the first scanning light beam may be coupled to the optical microcavity 40 and conducted in the optical microcavity 40. As shown in FIG. 3, after entering the optical microcavity 40 through the first waveguide 50, the first scanning light beam may be conducted in the optical microcavity 40 in the anti-clockwise direction. In addition, the frequency shifter 30 may transmit the third scanning light beam to the circulator 60 through the second port of the frequency shifter 30. The circulator 60 may receive the third scanning light beam through the second port of the circulator 60, and transmit the third scanning light beam to the first waveguide 50 through the first port of the circulator 60. The first waveguide 50 may receive the third scanning light beam through the second port of the first waveguide 50. In a process in which the third scanning light beam is transmitted from the second port to the first port of the first waveguide 50, when the third scanning light beam passes through the location that is of the first waveguide 50 and that is close to the optical microcavity 40, the third scanning light beam may be coupled to the optical microcavity 40 and conducted in the optical microcavity 40. As shown in FIG. 3, after entering the optical microcavity 40 through the first waveguide 50, the third scanning light beam may be conducted in the optical microcavity 40 in the clockwise direction. Further, when the first scanning light beam is in the red detuning region of the optical microcavity 40 and the third scanning light beam is in the blue detuning region of the optical microcavity 40, the optical microcavity 40 may generate and output the target light beam whose spectrum is the target optical frequency comb. The target light beam is coupled into the first waveguide 50 through the optical microcavity 40, is transmitted to the circulator 60 through the first waveguide 50, and is finally output by the third port of the circulator 60.

It should be noted herein that the foregoing describes functions of the first waveguide 50 and the circulator 60 by using an example of a scenario in which the first scanning light beam is input from the first port of the first waveguide 50 and the third scanning light beam is input from the second port of the first waveguide 50. In this case, the first scanning light beam is conducted in the optical microcavity 40 in the anti-clockwise direction, and the third scanning light beam is conducted in the optical microcavity 40 in the clockwise direction. In another optional scenario, the first scanning light beam may alternatively be input from the second port of the first waveguide 50, and the third scanning light beam may alternatively be input from the first port of the first waveguide 50. In this case, in the optical microcavity 40, the first scanning light beam is conducted in the clockwise direction, and the third scanning light beam is conducted in the anti-clockwise direction.

In the foregoing implementation, the first waveguide 50 and the circulator 60 are used to input the first scanning light beam and the third scanning light beam to the optical microcavity 40 and output the target light beam from the optical microcavity 40. This solution is simple and easy to implement, can reduce structural complexity of the optical frequency comb generation device 100, and can improve reliability of the optical frequency comb generation device 100.

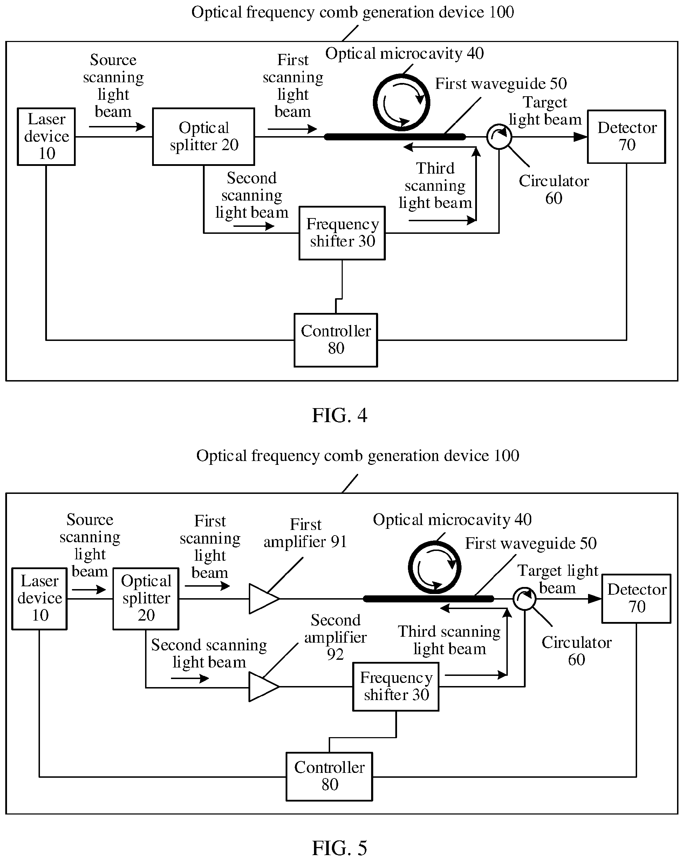

Further, based on the structure shown in FIG. 3, FIG. 4 is a schematic diagram of another structure of the optical frequency comb generation device according to an embodiment of this application. As shown in FIG. 4, the optical frequency comb generation device 100 further needs to include a detector 70 and a controller 80. The detector 70 is connected to the third port of the circulator 60, and the controller 80 is connected to the laser device 10, the frequency shifter 30, and the detector 70.

During actual work, the controller 80 is configured to generate a first control signal and send the first control signal to the laser device 10, where the first control signal is used to control a frequency of an output light beam of the laser device 10. The laser device 10 may generate the source scanning light beam based on the first control signal and output the source scanning light beam. The controller 80 is further configured to generate a second control signal and send the second control signal to the frequency shifter 30, where the second control signal includes the frequency shift amount corresponding to the frequency shifter 30. The frequency shifter 30 may add the frequency shift amount to an original frequency of the second scanning light beam based on the second control signal, to obtain and output the third scanning light beam. The detector 70 is configured to detect a light beam output by the third port of the circulator 60. Specifically, the detector 70 may be configured to: detect a spectrum of the light beam output by the third port of the circulator 60, and send the spectrum detected by the detector 70 to the controller 80. After receiving the spectrum from the detector 70, the controller 80 may parse the spectrum to determine whether the spectrum is the target optical frequency comb. When the first scanning light beam is in the red detuning region of the optical microcavity 40 and the third scanning light beam is in the blue detuning region of the optical microcavity 40, the third port of the circulator 60 may output the target light beam. The detector 70 may detect the spectrum of the target light beam and send the spectrum of the target light beam to the controller 80. After receiving the spectrum of the target light beam, the controller 80 may determine that the light beam output by the third port of the circulator 60 is the target light beam, and may also determine that the optical microcavity 40 generates the target optical frequency comb. Then, the controller 80 may transmit a third control signal to the laser device 10, to control, by using the third control signal, the laser device 10 to stop a change of the frequency of the source scanning light beam (to be specific, control the laser device 10 to keep a frequency of a current output light beam unchanged, and stop frequency scanning performed by the laser device 10). In addition, the controller 80 may further output a fourth control signal to the frequency shifter 30, to control, by using the fourth control signal, the frequency shifter 30 to stop a change of the frequency of the second scanning light beam (to be specific, control the frequency shifter to keep a frequency of a light beam output by the frequency shifter equal to a frequency of a light beam input by the frequency shifter, and stop frequency scanning performed by the frequency shifter). When the first scanning light beam is not in the red detuning region of the optical microcavity 40 and/or the third scanning light beam is not in the blue detuning region of the optical microcavity 40, after the detector 70 sends, to the controller 80, the spectrum that is of the light beam output by the third port of the circulator 60 and that is detected by the detector 70, the controller 80 may determine, through analysis, that the light beam output by the third port of the circulator 60 is not the target light beam, and may also determine that the optical microcavity 40 has not generated the target optical frequency comb. Then, the controller 80 may continue to control the laser device 10 to generate the source scanning light beam, and continue to control the frequency shifter 30 to generate the third scanning light beam. In short, the detector 70 is configured to detect the light beam output by the third port of the circulator 60. The controller 80 is configured to: when determining, through the detector 70, that the light beam output by the third port of the circulator 60 is not the target light beam, continue to control the laser device 10 and the frequency shifter 30 to perform frequency scanning. The controller 80 is further configured to: when determining, through the detector 70, that the light beam output by the third port of the circulator 60 is the target light beam, control the laser device 10 to stop the change of the frequency of the source scanning light beam, and control the frequency shifter 30 to stop a change of the frequency of the third scanning light beam.

In some feasible implementations, FIG. 5 is a schematic diagram of another structure of the optical frequency comb generation device according to an embodiment of this application. As shown in FIG. 5, the optical frequency comb generation device 100 may further include a first amplifier 91 and a second amplifier 92. The second port of the optical splitter 20 is connected to the first port of the first waveguide 50 through the first amplifier 91. In other words, one port of the first amplifier 91 is connected to the second port of the optical splitter 20, and another port of the first amplifier 91 is connected to the first port of the first waveguide 50. The third port of the optical splitter 20 is connected to the first port of the frequency shifter 30 through the second amplifier 92. In other words, one port of the second amplifier 92 is connected to the third port of the optical splitter 20, and another port of the second amplifier 92 is connected to the first port of the frequency shifter 30.

During actual work, the first amplifier 91 is configured to: adjust the optical power of the first scanning light beam, and transmit the first scanning light beam obtained after optical power adjustment to the first waveguide 50. Herein, an optical power of the first scanning light beam obtained after the optical power adjustment needs to be greater than or equal to the nonlinear effect power threshold of the optical microcavity 40. The second amplifier 92 is configured to: adjust an optical power of the second scanning light beam, and transmit the second scanning light beam obtained after optical power adjustment to the frequency shifter 30. For example, the first amplifier 91 may be configured to: adjust the optical power of the first scanning light beam to a first preset optical power, and transmit the first scanning light beam at the first preset optical power to the first waveguide 50. Herein, the first preset optical power is greater than or equal to the nonlinear effect power threshold corresponding to the optical microcavity 40. The second amplifier 92 may be configured to: adjust the optical power of the second scanning light beam to a second preset optical power, and transmit the second scanning light beam at the second preset optical power to the frequency shifter 30, so that the optical power of the third scanning light beam that subsequently enters the optical microcavity 40 may be the second preset optical power. Herein, the first preset optical power and the second preset optical power may be empirical values obtained by performing a plurality of target optical frequency comb generation experiments on the optical frequency comb generation device 100 provided in this application. Optical powers of the first scanning light beam and the second scanning light beam are set to these empirical values, so that $\Delta\delta_A$ and $\Delta v_{NL}$ that have the decisive effect on the detuning amount jitter of the first scanning light beam may be completely canceled by each other. Therefore, the optical frequency comb generation device 100 can completely eliminate the noise of the random change of the optical frequency comb spacing that is caused by the detuning amount jitter of the first scanning light beam.

In the foregoing implementation, the first amplifier 91 and the second amplifier 92 are added to the optical frequency comb generation device 100, so that adjustment of the optical powers of the first scanning light beam and the second scanning light beam can be facilitated, and function flexibility of the optical frequency comb generation device 100 is improved. In addition, the first amplifier 91 and the second amplifier 92 may be further used to adjust the optical power of the first scanning light beam to the first preset optical power, and adjust the optical power of the second scanning light beam to the second preset optical power, so that the noise of the random change of the optical frequency comb spacing that is caused by the detuning amount jitter of the first scanning light beam can be completely eliminated. This helps ensure the narrow linewidth performance of the target optical frequency comb.

Optionally, the first amplifier 91 and the second amplifier 92 may be specifically optical amplifiers, for example, semiconductor optical amplifiers (semiconductor optical amplifiers, SOAs), erbium-doped optical fiber amplifiers (erbium-doped optical fiber amplifiers, EDFAs), or Raman amplifiers (Raman fiber amplifiers, RFAs). Specific implementation forms of the first amplifier 91 and the second amplifier 92 are not limited in this application.

It should be additionally noted that, as described above, the optical frequency comb generation device 100 includes both the first amplifier 91 and the second amplifier 92. However, in an optional implementation, the optical frequency comb generation device 100 includes only the first amplifier 91, and a location and a function of the first amplifier 91 are the same as those described above. In another optional implementation, when the optical power of the first scanning light beam is greater than the nonlinear effect power threshold of the optical microcavity 40, the optical frequency comb generation device 100 may alternatively include only the second amplifier 92, and a location and a function of the second amplifier 92 are the same as those described above. In addition, in a scenario in which the optical frequency comb generation device 100 includes the second amplifier 92, the second amplifier 92 may be disposed between the optical splitter 20 and the frequency shifter 30, as shown in FIG. 5. Alternatively, the second amplifier 92 may be disposed between the frequency shifter 30 and the circulator 60. In this case, the second amplifier 92 may be configured to: adjust the optical power of the third scanning light beam output by the frequency shifter 30, and transmit the third scanning light beam obtained after optical power adjustment to the circulator 60. It should be understood that the foregoing is described by using only an example of a scenario in which the optical frequency comb generation device 100 includes both the first amplifier 91 and the second amplifier 92, and the second amplifier 92 is disposed between the optical splitter 20 and the frequency shifter 30. However, during actual implementation, whether the first amplifier 91 and the second amplifier 92 exist and how to set a location of the second amplifier 92 may be further combined to obtain a plurality of other optional implementations. These optional implementations are not enumerated in this application, but these optional implementations should also fall within the protection scope of this application.

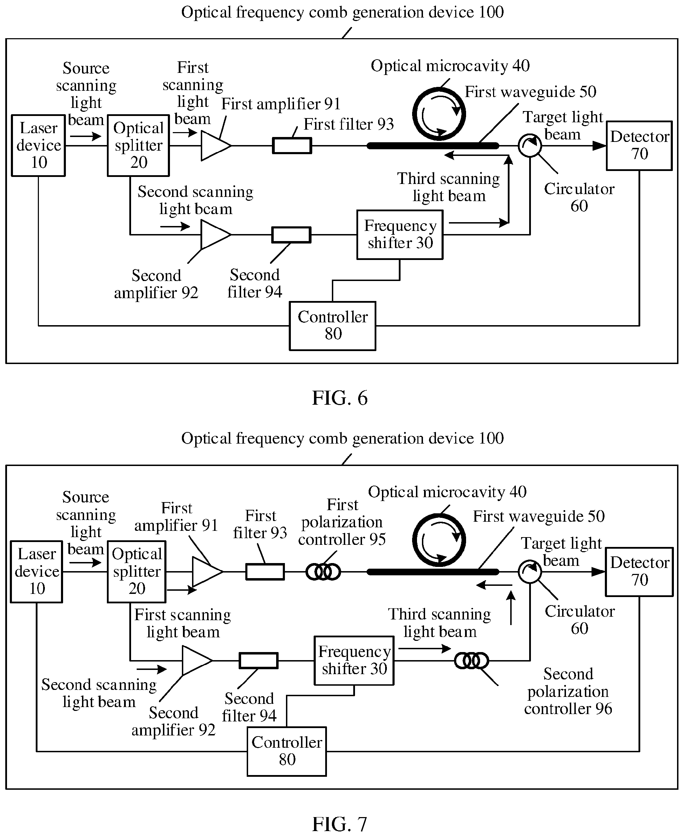

In some feasible implementations, FIG. 6 is a schematic diagram of another structure of the optical frequency comb generation device according to an embodiment of this application. As shown in FIG. 6, the optical frequency comb generation device 100 may further include a first filter 93 and a second filter 94. The first amplifier 91 is connected to the first port of the first waveguide 50 through the first filter 93 (in other words, one port of the first filter 93 is connected to one port of the first amplifier 91, and another port of the first filter 93 is connected to the first port of the first waveguide 50). The second amplifier 92 is connected to the frequency shifter 30 through the second filter 94 (in other words, one port of the second filter 94 is connected to one port of the second amplifier 92, and another port of the second filter 94 is connected to the first port of the frequency shifter 30).

During actual work, the first filter 93 is configured to: perform noise filtering on the first scanning light beam (that is, the first scanning light beam obtained after the power adjustment) from the first amplifier 91, and transmit the first scanning light beam obtained after the noise filtering to the first waveguide 50. Herein, the first filter 93 is mainly configured to filter out noise introduced when the first amplifier 91 adjusts the power of the first scanning light beam. The second filter 94 is configured to: perform noise filtering on the second scanning light beam (that is, the second scanning light beam obtained after the power adjustment) from the second amplifier 92, and transmit the second scanning light beam obtained after the noise filtering to the frequency shifter 30. Herein, the second filter 94 is mainly configured to filter out noise introduced when the second amplifier 92 adjusts the power of the second scanning light beam.

In the foregoing implementation, the first filter 93 and the second filter 94 are added to the optical frequency comb generation device, so that noise introduced by the first scanning light beam and the second scanning light beam due to power adjustment can be filtered out through the two components. In this way, generation efficiency of the target optical frequency comb can be improved, and stability of the target optical frequency comb can be ensured.

Optionally, the first filter 93 and the second filter 94 are specifically wide-spectrum noise filters, for example, acoustic-optic tunable filters, arrayed waveguide grating filters, and Mach-Zehnder interference filters. Specific implementation forms of the first filter 93 and the second filter 94 are not limited in this application.

It should also be noted that, the foregoing describes a case in which the optical frequency comb generation device 100 includes both the first filter 93 and the second filter 94. In an optional implementation, the optical frequency comb generation device 100 may include only the first filter 93, and a location and a function of the first filter 93 are the same as those described above (mainly corresponding to a scenario in which the optical frequency comb generation device 100 includes only the first amplifier 91). In another optional implementation, the optical frequency comb generation device 100 may alternatively include only the second filter 94, and a location and a function of the second filter 94 are the same as those described above (mainly corresponding to a scenario in which the optical frequency comb generation device 100 includes only the second amplifier 92). In addition, in a scenario in which the optical frequency comb generation device 100 includes the second filter 94, when the second amplifier 92 is disposed between the frequency shifter 30 and the circulator 60, the second filter 94 may be disposed between the second amplifier 92 and the circulator 60. In this case, the second filter 94 is configured to: perform noise filtering on the third scanning light beam obtained after the optical power adjustment, and transmit the third scanning light beam obtained after the optical noise filtering to the circulator 60. It should be understood that the foregoing is described by using only an example of a scenario in which the optical frequency comb generation device 100 includes both the first filter 93 and the second filter 94, and the second filter 94 is disposed between the second amplifier 92 and the frequency shifter 30. However, during actual implementation, whether both the first filter 93 and the second filter 94 exist and how to set a location of the second filter 94 may be further combined to obtain a plurality of other optional implementations. These optional implementations are not enumerated in this application, but these optional implementations should also fall within the protection scope of this application.

In some feasible implementations, FIG. 7 is a schematic diagram of another structure of the optical frequency comb generation device according to an embodiment of this application. As shown in FIG. 7, the optical frequency comb generation device 100 further includes a first polarization controller 95 and a second polarization controller 96. The first filter 93 is connected to the first port of the first waveguide 50 through the first polarization controller 95, and the frequency shifter 30 is connected to the second port of the circulator 60 through the second polarization controller 96.

During actual work, the first polarization controller 95 is configured to: adjust a polarization state of the first scanning light beam (that is, the first scanning light beam obtained after the filtering) from the first filter 93 to a target polarization state corresponding to the optical microcavity 40 (in other words, adjust the polarization state of the first scanning light beam to be consistent with a working polarization state of the optical microcavity 40), and transmit the first scanning light beam (that is, the first scanning light beam in the target polarization state) obtained after polarization state adjustment to the first waveguide 50. The second polarization controller 96 is configured to: adjust a polarization state of the third scanning light beam (that is, the third scanning light beam obtained after the filtering) from the frequency shifter 30 to the target polarization state corresponding to the optical microcavity 40 (in other words, adjust the polarization state of the third scanning light beam to be consistent with the working polarization state of the optical microcavity 40), and transmit the third scanning light beam (that is, the third scanning light beam in the target polarization state) obtained after polarization state adjustment to the circulator 60.

In the foregoing implementation, the first polarization controller 95 and the second polarization controller 96 are added to the optical frequency comb generation device 100, so that polarization states of the first scanning light beam and the third scanning light beam that enter the optical microcavity 40 can be adjusted through the two components. In this way, the polarization states of the first scanning light beam and the third scanning light beam are consistent with the target polarization state of the optical microcavity 40. In an aspect, this can improve optical conversion efficiency of the optical microcavity 40, and further improve the generation efficiency of the target optical frequency comb. In another aspect, other elements in the device may also use non-polarization-maintaining optical components, so that costs of the optical frequency comb generation device 100 can be reduced.

It should be noted herein that the first polarization controller 95 and the second polarization controller 96 may be specifically various forms of optical components that have polarization state control performance, for example, slide-type polarization controllers or optical fiber ring polarization controllers. This is not specifically limited in this application.

It should be additionally noted herein that the foregoing implementation describes a case in which the optical frequency comb generation device 100 includes both the first polarization controller 95 and the second polarization controller 96. In an optional implementation, the optical frequency comb generation device 100 may include only the first polarization controller 95, and a location and a function of the first polarization controller 95 are the same as those described above. In another optional implementation, the optical frequency comb generation device 100 may alternatively include only the second polarization controller 96, and a location and a function of the second polarization controller 96 are the same as those described above. In addition, in a scenario in which the optical frequency comb generation device 100 includes the first polarization controller 95, the first polarization controller 95 may be disposed between the first filter 93 and the first waveguide 50, as shown in FIG. 7. Alternatively, the first polarization controller 95 may be disposed between the first amplifier 91 and the first filter 93, or may be disposed between the optical splitter 20 and the first amplifier 91. Herein, a location of the first polarization controller 95 may be set based on an actual application requirement, provided that it is ensured that the first polarization controller 95 can perform polarization state control on the first scanning light beam before the first scanning light beam enters the optical microcavity 40. The location of the first polarization controller 95 is not specifically limited in this application. Similarly, in a scenario in which the optical frequency comb generation device 100 includes the second polarization controller 96, the second polarization controller 96 may be disposed between the frequency shifter 30 and the circulator 60, as shown in FIG. 7. Alternatively, the second polarization controller 96 may be disposed between the second filter 94 and the frequency shifter 30, may be disposed between the second amplifier 92 and the second filter 94, or may be disposed between the optical splitter 20 and the second amplifier 92. Herein, a location of the second polarization controller 96 may be set based on an actual application requirement, provided that it is ensured that the second polarization controller 96 can perform polarization state control on the third scanning light beam or the second scanning light beam before the third scanning light beam or the second scanning light beam enters the optical microcavity 40. The location of the second polarization controller 96 is not specifically limited in this application. Therefore, during actual implementation, whether both the first polarization controller 95 and the second polarization controller 96 exist and how to set locations of the first polarization controller 95 and the second polarization controller 96 may be further combined to obtain a plurality of other optional implementations. These optional implementations are not enumerated in this application, but these optional implementations should also fall within the protection scope of this application.

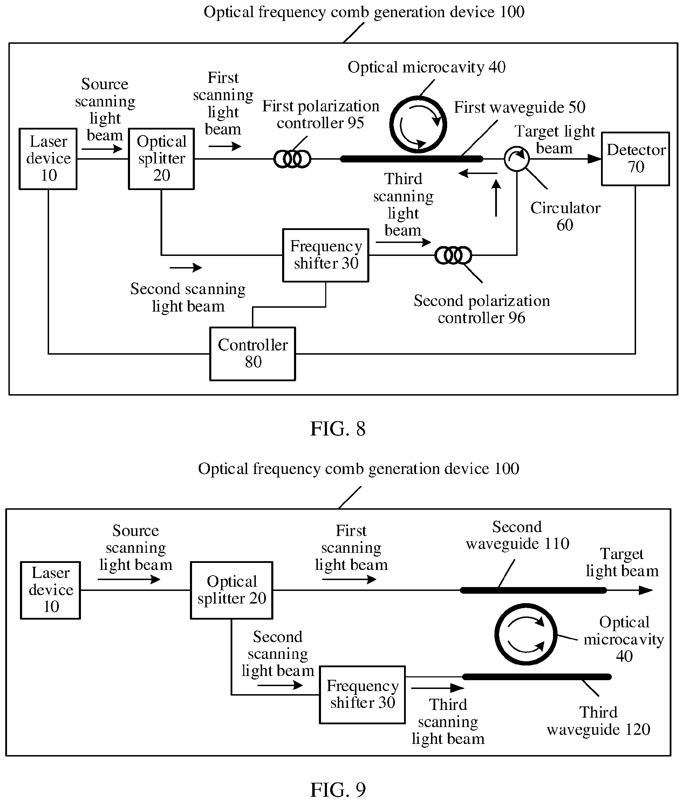

It should be understood that, in FIG. 7, a scenario in which the optical frequency comb generation device 100 includes the first amplifier 91, the second amplifier 92, the first filter 93, and the second filter 94 is used as an example to describe functions of the first polarization controller 95 and the second polarizer 96. However, in another optional implementation, the optical frequency comb generation device 100 may include only the first polarization controller 95 and the second polarization controller 96. For example, FIG. 8 is a schematic diagram of another structure of the optical frequency comb generation device according to an embodiment of this application. As shown in FIG. 8, the optical frequency comb generation device 100 does not include the first amplifier 91, the second amplifier 92, the first filter 93, and the second filter 94, and includes only the first polarization controller 95 and the second polarization controller 96. One port of the first polarization controller 95 is connected to the optical splitter 20, and another port is connected to the first waveguide 50. The first polarization controller 95 is configured to adjust a polarization state of the first scanning light beam output by the optical splitter 20 to the target polarization state corresponding to the optical microcavity 40. The second polarization controller 96 is disposed between the frequency shifter 30 and the circulator 60, and is configured to adjust a polarization state of the third scanning light beam to the target polarization state corresponding to the optical microcavity 40. Alternatively, the second polarization controller 96 may be disposed between the optical splitter 20 and the frequency shifter 30, and is configured to adjust a polarization state of the second scanning light beam to the target polarization state corresponding to the optical microcavity 40.

In some feasible implementations, as described above, when determining, through the detector 70, that the light beam output by the third port of the circulator 60 is the target light beam, the controller 80 controls the laser device 10 to stop the change of the frequency of the source scanning light beam, and controls the frequency shifter 30 to stop the change of the frequency of the third scanning light beam. Although the optical frequency comb generation device 100 has generated the target optical frequency comb, some external environmental factors (for example, an ambient temperature change of the optical frequency comb generation device 100) easily cause a change of a light beam output by the optical frequency comb generation device 100. To be specific, the optical frequency comb generated by the optical frequency comb generation device 100 is no longer a target optical frequency comb with a narrow linewidth.

Therefore, to resolve a stability problem of the target optical frequency comb, when the optical microcavity 40 generates the target light beam, the detector may be further configured to: detect the target light beam output by the third port of the circulator 60, to obtain an optical power of the target light beam, and feed back the optical power of the target light beam to the controller 80. The controller 80 may receive and store the optical power of the target light beam. Then, the detector 70 may continue to detect an optical power of the light beam output by the third port of the circulator 60, and feed back the optical power of the light beam output by the third port of the circulator 60 to the controller 80. The controller 80 is configured to determine, based on the optical power fed back by the detector 70 and the optical power that is of the target light beam and that is pre-stored in the controller 80, whether the optical power of the light beam output by the third port of the circulator 60 changes (in other words, determine whether the light beam output by the third port of the circulator 60 is still the target light beam). Specifically, the controller 80 may compare the optical power that is of the light beam output by the third port of the circulator 60 and that is subsequently detected by the detector 70 with the optical power of the target light beam. If determining that the optical power of the light beam output by the third port of the circulator 60 is not equal to the optical power of the target light beam, or determining that a difference between the optical power of the light beam output by the third port of the circulator 60 and the optical power of the target light beam is greater than a preset deviation value, the controller 80 may determine that the optical power of the light beam output by the third port of the circulator 60 changes, and may also determine that the light beam output by the third port of the circulator 60 is no longer the target light beam. Then, the controller 80 may be further configured to control the frequency shifter 30 to change the frequency of the third scanning light beam again until the optical power of the light beam output by the third port of the circulator 60 is restored to the optical power of the target light beam (in other words, until it is determined that the light beam output by the third port of the circulator 60 is the target light beam again). Specifically, the controller 80 may control the frequency shifter 30 to gradually increase the frequency of the third scanning light beam. In this process, the detector 70 continuously detects and feeds back, to the controller 80, the optical power of the light beam output by the third port of the circulator 60. The controller 80 determines, based on the optical power fed back by the detector 70, whether the optical power of the light beam output by the third port of the circulator 60 is restored to the optical power of the target light beam. If determining that the optical power of the light beam output by the third port of the circulator 60 has been restored to the optical power of the target light beam, the controller 80 may control the frequency shifter 30 again to stop a change of the frequency of the third scanning light beam. If determining, after a period of time, that the optical power of the light beam output by the third port of the circulator 60 still cannot be restored to the optical power of the target light beam, the controller 80 may control the frequency shifter 30 to gradually reduce the frequency of the third scanning light beam. In this process, the controller 80 cooperates with the detector 70 to continue to determine whether the optical power of the light beam output by the third port of the circulator 60 is restored to the optical power of the target light beam. If determining, at a specific moment, that the optical power of the light beam output by the third port of the circulator 60 has been restored to the optical power of the target light beam, the controller 80 may control the frequency shifter 30 again to stop a change of the frequency of the third scanning light beam.

In the foregoing implementation, when the optical power of the light beam output by the third port of the circulator 60 changes (in other words, the optical power of the light beam is no longer the optical power of the target light beam), the controller 80 may be used to control the frequency shifter 30 to change the frequency of the third scanning light beam, to enable the optical power of the light beam output by the third port of the circulator 60 to be restored to the optical power of the target light beam. In this way, it can be ensured that the optical frequency comb generation device 100 can continuously and stably output the target optical frequency comb, and applicability of the optical frequency comb generation device 100 can be improved.

In some feasible implementations, FIG. 9 is a schematic diagram of another structure of the optical frequency comb generation device according to an embodiment of this application. It should be understood that in FIG. 9, the optical microcavity 40 is also shown in a form of a microring. As shown in FIG. 9, the optical frequency comb generation device not only includes the laser device 10, the optical splitter 20, the frequency shifter 30, and the optical microcavity 40 described above, but also includes a second waveguide 110 and a third waveguide 120. A first port of the optical splitter 20 is connected to the laser device 10, and a second port of the optical splitter 20 is connected to a first port of the second waveguide 110. The optical microcavity 40 is coupled between the first port and a second port of the second waveguide 110 (in other words, the optical microcavity 40 is disposed at a location close to the second waveguide 110, the optical microcavity 40 and the second waveguide 110 are close to each other but are not in contact with each other, and there is a specific distance between the optical microcavity 40 and the second waveguide 110). A third port of the optical splitter 20 is connected to a first port of the frequency shifter 30, and a second port of the frequency shifter 30 is connected to a first port of the third waveguide 120. The optical microcavity 40 is also coupled between the first port and a second port of the third waveguide 120 (in other words, the optical microcavity 40 is disposed at a location close to the third waveguide 120, the optical microcavity 40 and the third waveguide 120 are close to each other but are not in contact with each other, and there is a specific distance between the optical microcavity 40 and the third waveguide 120). Optionally, both the second waveguide 110 and the third waveguide 120 are straight waveguides.

During actual work, the second waveguide 110 is configured to transmit the first scanning light beam to the optical microcavity 40, and the third waveguide 120 is configured to transmit the third scanning light beam to the optical microcavity 40. When the optical microcavity 40 outputs the target light beam, a third port of the second waveguide 110 is further configured to output the target light beam. Specifically, the optical splitter 20 may transmit the first scanning light beam to the second waveguide 110 through the second port of the optical splitter 20. The second waveguide 110 may receive the first scanning light beam through the first port of the second waveguide 110. In a process in which the first scanning light beam is transmitted from the first port to the second port of the second waveguide 110, when the first scanning light beam passes through a location close to the optical microcavity 40, the first scanning light beam may be coupled to the optical microcavity 40 and conducted in the optical microcavity 40. In addition, the frequency shifter 30 may transmit the third scanning light beam to the third waveguide 120 through the second port of the frequency shifter 30. The third waveguide 120 may receive the third scanning light beam through the first port of the third waveguide 120. In a process in which the third scanning light beam is transmitted from the first port to the second port of the third waveguide 120, when the third scanning light beam passes through a location close to the optical microcavity 40, the third scanning light beam may be coupled to the optical microcavity 40 and conducted in the optical microcavity 40. Herein, as described above, the first scanning light beam and the third scanning light beam are transmitted in opposite directions in the optical microcavity 40. Further, when the first scanning light beam is in the red detuning region of the optical microcavity 40 and the third scanning light beam is in the blue detuning region of the optical microcavity 40, the optical microcavity 40 may generate and output the target light beam whose spectrum is the target optical frequency comb. The target light beam is coupled into the second waveguide 110 through the optical microcavity 40, and is finally output by the second port of the second waveguide 110. Herein, for functions of the laser device 10, the optical splitter 20, the frequency shifter 30, and the optical microcavity 40, refer to the foregoing descriptions. Details are not described herein again.

In the foregoing implementation, the second waveguide 110 and the third waveguide 120 are used to input the first scanning light beam and the third scanning light beam to the optical microcavity 40 and output the target light beam from the optical microcavity 40. This solution is simple and has low costs, and can reduce costs of the optical frequency comb generation device 100 while reducing structural complexity of the optical frequency comb generation device 100.

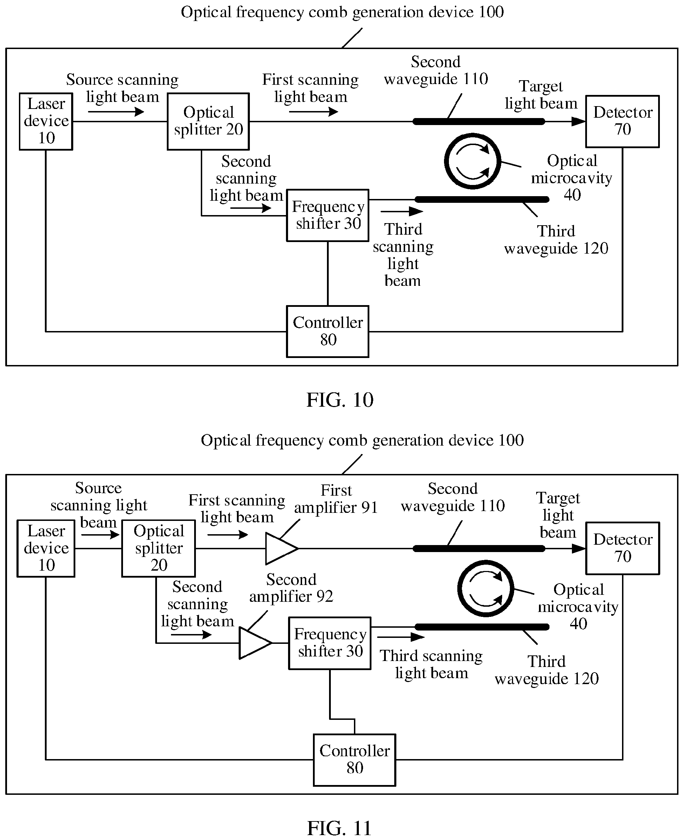

In some feasible implementations, based on the structure shown in FIG. 9, FIG. 10 is a schematic diagram of another structure of the optical frequency comb generation device according to an embodiment of this application. As shown in FIG. 10, the optical frequency comb generation device 100 further needs to include a detector 70 and a controller 80. The detector 70 is connected to the second port of the second waveguide 110, and the controller 80 is connected to the laser device 10, the frequency shifter 30, and the detector 70.

During actual work, the controller 80 is configured to control, by using a first control signal, the laser device 10 to generate and output the source scanning light beam. The controller 80 is further configured to control, by using a second control signal, the frequency shifter 30 to generate the third scanning light beam based on the second scanning light beam and output the third scanning light beam. For a specific process, refer to a corresponding process described above. Details are not described herein again.

Further, the detector 70 is configured to detect a light beam output by the second port of the second waveguide 110. Specifically, the detector 70 may be configured to: detect a spectrum of the light beam output by the second port of the second waveguide 110, and send the spectrum detected by the detector 70 to the controller 80. After receiving the spectrum from the detector 70, the controller 80 may parse the spectrum to determine whether the spectrum is the target optical frequency comb (in other words, determine whether the light beam output by the second port of the second waveguide 110 is the target light beam). Herein, a specific process in which the controller 80 determines, based on the spectrum detected by the detector 70, whether the light beam output by the second port of the second waveguide 110 is the target light beam is similar to the foregoing described process in which the controller 80 determines, based on the spectrum detected by the detector 70, whether the light beam output by the third port of the circulator 60 is the target light beam. Therefore, reference may be made to the foregoing descriptions. When determining that the light beam output by the second port of the second waveguide 110 is the target light beam, the controller 80 may control, by using a third control signal, the laser device 10 to stop a change of the frequency of the source scanning light beam. In addition, the controller 80 may further control, by using a fourth control signal, the frequency shifter 30 to stop a change of the frequency of the second scanning light beam. However, when determining, through analysis, that the light beam output by the second port of the second waveguide 110 is not the target light beam, the controller 80 may continue to control the laser device 10 to generate the source scanning light beam, and continue to control the frequency shifter 30 to generate the third scanning light beam.

In some feasible implementations, FIG. 11 is a schematic diagram of another structure of the optical frequency comb generation device according to an embodiment of this application. As shown in FIG. 11, the optical frequency comb generation device 100 may further include a first amplifier 91 and a second amplifier 92. The second port of the optical splitter 20 is connected to the first port of the second waveguide 110 through the first amplifier 91. The third port of the optical splitter 20 is connected to the first port of the frequency shifter 30 through the second amplifier 92.

During actual work, the first amplifier 91 is configured to: adjust the optical power of the first scanning light beam, and transmit the first scanning light beam obtained after optical power adjustment to the second waveguide 110. Herein, an optical power of the first scanning light beam obtained after the optical power adjustment needs to be greater than or equal to the nonlinear effect power threshold of the optical microcavity 40. The second amplifier 92 is configured to: adjust an optical power of the second scanning light beam, and transmit the second scanning light beam obtained after optical power adjustment to the frequency shifter 30. For example, the first amplifier 91 may be configured to: adjust the optical power of the first scanning light beam to a first preset optical power, and transmit the first scanning light beam at the first preset optical power to the second waveguide 110. Herein, the first preset optical power is greater than or equal to the nonlinear effect power threshold corresponding to the optical microcavity 40. The second amplifier 92 may be configured to: adjust the optical power of the second scanning light beam to a second preset optical power, and transmit the second scanning light beam at the second preset optical power to the frequency shifter 30, so that the optical power of the third scanning light beam that subsequently enters the optical microcavity 40 may be the second preset optical power. Herein, for explanations of the first preset optical power and the second preset optical power, refer to the foregoing descriptions. Optical powers of the first scanning light beam and the second scanning light beam are set to preset optical powers, so that $\Delta\delta_A$ and $\Delta v_{NL}$ that have the decisive effect on the detuning amount jitter of the first scanning light beam may be completely canceled by each other. Therefore, the optical frequency comb generation device 100 can completely eliminate the noise of the random change of the optical frequency comb spacing that is caused by the detuning amount jitter of the first scanning light beam.

In the foregoing implementation, the first amplifier 91 and the second amplifier 92 are added to the optical frequency comb generation device 100, so that adjustment of the optical powers of the first scanning light beam and the second scanning light beam can be facilitated, and function flexibility of the optical frequency comb generation device 100 is improved. In addition, the first amplifier 91 and the second amplifier 92 may be further used to adjust the optical power of the first scanning light beam to the first preset optical power, and adjust the optical power of the second scanning light beam to the second preset optical power, so that the noise of the random change of the optical frequency comb spacing that is caused by the detuning amount jitter of the first scanning light beam can be completely eliminated. This helps ensure the narrow linewidth performance of the target optical frequency comb.

Herein, for specific implementation forms of the first amplifier 91 and the second amplifier 92, refer to the foregoing descriptions. Details are not described herein again.

Similar to the foregoing descriptions, in the foregoing implementation, a scenario in which the optical frequency comb generation device 100 includes both the first amplifier 91 and the second amplifier 92 is used as an example. However, during actual implementation, the optical frequency comb generation device 100 may alternatively include only one of the first amplifier 91 and the second amplifier 92. In addition, in a scenario in which the optical frequency comb generation device 100 includes the second amplifier 92, the second amplifier 92 may be disposed between the optical splitter 20 and the frequency shifter 30, as shown in FIG. 11. Alternatively, the second amplifier 92 may be disposed between the frequency shifter 30 and the third waveguide 120. In this case, the second amplifier 92 is mainly configured to: adjust the optical power of the third scanning light beam output by the frequency shifter 30, and transmit the third scanning light beam obtained after optical power adjustment to the third waveguide 120. It should be understood that, during actual implementation, whether the first amplifier 91 and the second amplifier 92 exist and how to set a location of the second amplifier 92 may be further combined to obtain a plurality of other optional implementations. These optional implementations are not enumerated in this application, but these optional implementations should also fall within the protection scope of this application.

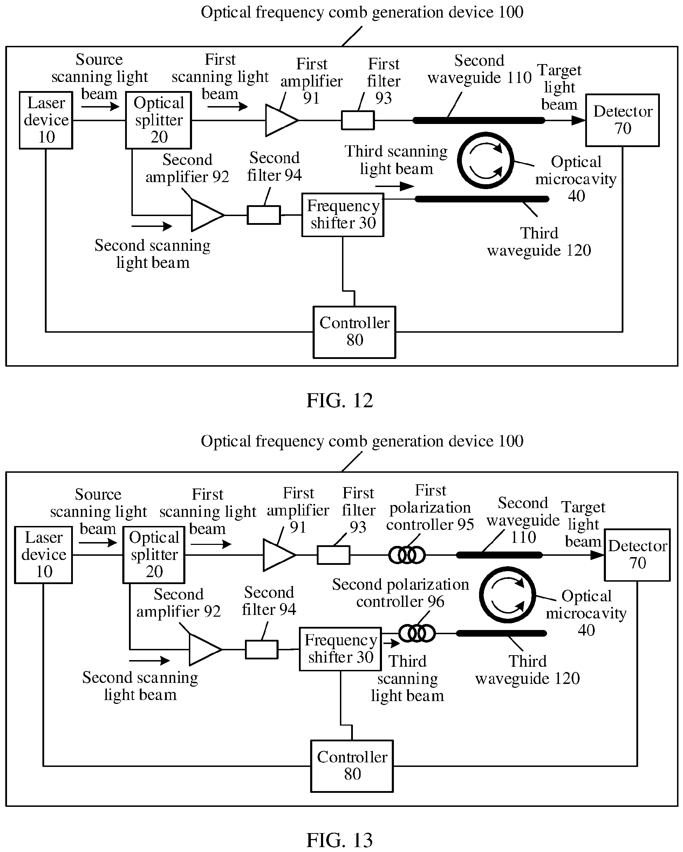

In some feasible implementations, FIG. 12 is a schematic diagram of another structure of the optical frequency comb generation device according to an embodiment of this application. As shown in FIG. 12, the optical frequency comb generation device 100 may further include a first filter 93 and a second filter 94. The first amplifier 91 is connected to the first port of the second waveguide 110 through the first filter 93, and the second amplifier 92 is connected to the frequency shifter 30 through the second filter 94. During actual work, the first filter 93 is configured to: perform noise filtering on the first scanning light beam from the first amplifier 91, and transmit the first scanning light beam obtained after the noise filtering to the second waveguide 110. The second filter 94 is configured to: perform noise filtering on the second scanning light beam from the second amplifier 92, and transmit the second scanning light beam obtained after the noise filtering to the frequency shifter 30.

In the foregoing implementation, the first filter 93 and the second filter 94 are added to the optical frequency comb generation device, so that noise introduced by the first scanning light beam and the second scanning light beam due to power adjustment can be filtered out through the two components. In this way, generation efficiency of the target optical frequency comb can be improved, and stability of the target optical frequency comb can be ensured.

Herein, for specific descriptions of the first filter 93 and the second filter 94, refer to the foregoing descriptions. Details are not described herein again.

It should also be noted that the foregoing implementation is described by using a case in which the optical frequency comb generation device 100 includes both the first filter 93 and the second filter 94. However, during actual implementation, the optical frequency comb generation device 100 may alternatively include only one of the first filter 93 and the second filter 94. Preferably, if the first amplifier 91 exists, the first filter 93 correspondingly exists; and if the second amplifier 92 exists, the second filter 94 correspondingly exists. In addition, in a scenario in which the optical frequency comb generation device 100 includes the second filter 94, when the second amplifier 92 is disposed between the frequency shifter 30 and the third waveguide 120, the second filter 94 may be disposed between the second amplifier 92 and the third waveguide 120. In this case, the second filter 94 is configured to: perform noise filtering on the third scanning light beam, and transmit the third scanning light beam obtained after the optical noise filtering to the third waveguide 120. It should be understood that, during actual implementation, whether both the first filter 93 and the second filter 94 exist and how to set a location of the second filter 94 may be further combined to obtain a plurality of other optional implementations. These optional implementations are not enumerated in this application, but these optional implementations should also fall within the protection scope of this application.

In some feasible implementations, FIG. 13 is a schematic diagram of another structure of the optical frequency comb generation device according to an embodiment of this application. As shown in FIG. 13, the optical frequency comb generation device 100 further includes a first polarization controller 95 and a second polarization controller 96. The first filter 93 is connected to the first port of the second waveguide 110 through the first polarization controller 95, and the frequency shifter 30 is connected to the first port of the third waveguide 120 through the second polarization controller 96. During actual work, the first polarization controller 95 is configured to adjust a polarization state of the first scanning light beam from the first filter 93 to a target polarization state corresponding to the optical microcavity 40. The second polarization controller 96 is configured to adjust a polarization state of the third scanning light beam from the frequency shifter 30 to the target polarization state corresponding to the optical microcavity 40.

In the foregoing implementation, the first polarization controller 95 and the second polarization controller 96 are added to the optical frequency comb generation device 100, so that polarization states of the first scanning light beam and the third scanning light beam that enter the optical microcavity 40 can be adjusted through the two components. In this way, the polarization states of the first scanning light beam and the third scanning light beam are consistent with the target polarization state of the optical microcavity 40. In an aspect, this can improve optical conversion efficiency of the optical microcavity 40, and further improve the generation efficiency of the target optical frequency comb. In another aspect, other elements in the device may also use non-polarization-maintaining optical components, so that the costs of the optical frequency comb generation device 100 can be reduced.

Herein, for type selection descriptions of the first polarization controller 95 and the second polarization controller 96, refer to the foregoing descriptions. Details are not described herein again.

It should be additionally noted herein that the foregoing implementation is described by using an example in which the optical frequency comb generation device 100 includes both the first polarization controller 95 and the second polarization controller 96. However, during actual implementation, the optical frequency comb generation device 100 may alternatively include only one of the first polarization controller 95 and the second polarization controller 96. In addition, in a scenario in which the optical frequency comb generation device 100 includes the first polarization controller 95, the first polarization controller 95 may be disposed between the first filter 93 and the second waveguide 110, as shown in FIG. 13.

Alternatively, the first polarization controller 95 may be disposed between the first amplifier 91 and the first filter 93, or may be disposed between the optical splitter 20 and the first amplifier 91, provided that it is ensured that the first polarization controller 95 can perform polarization state control on the first scanning light beam before the first scanning light beam enters the optical microcavity 40. Similarly, in a scenario in which the optical frequency comb generation device 100 includes the second polarization controller 96, the second polarization controller 96 may be disposed between the frequency shifter 30 and the second waveguide 120, as shown in FIG. 13. Alternatively, the second polarization controller 96 may be disposed between the second filter 94 and the frequency shifter 30, may be disposed between the second amplifier 92 and the second filter 94, or may be disposed between the optical splitter 20 and the second amplifier 92, provided that it is ensured that the second polarization controller 96 can perform polarization state control on the third scanning light beam or the second scanning light beam before the third scanning light beam or the second scanning light beam enters the optical microcavity 40. It should be understood that, during actual implementation, whether both the first polarization controller 95 and the second polarization controller 96 exist and how to set locations of the first polarization controller 95 and the second polarization controller 96 may be further combined to obtain a plurality of other optional implementations. These optional implementations are not enumerated in this application, but these optional implementations should also fall within the protection scope of this application.

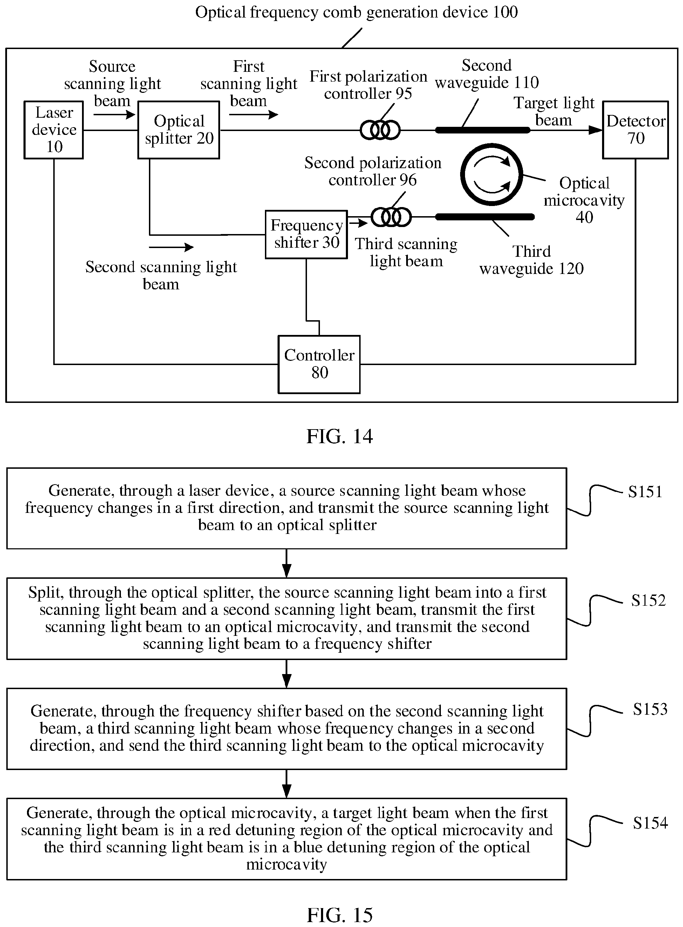

It should be understood that, in FIG. 13, a scenario in which the optical frequency comb generation device 100 includes the first amplifier 91, the second amplifier 92, the first filter 93, and the second filter 94 is used as an example to describe functions of the first polarization controller 95 and the second polarization controller 96. However, in an optional implementation, the optical frequency comb generation device 100 may include only the first polarization controller 95 and the second polarization controller 96. For example, FIG. 14 is a schematic diagram of another structure of the optical frequency comb generation device according to an embodiment of this application. As shown in FIG. 14, the optical frequency comb generation device 100 does not include the first amplifier 91, the second amplifier 92, the first filter 93, and the second filter 94, and includes only the first polarization controller 95 and the second polarization controller 96. One port of the first polarization controller 95 is connected to the optical splitter 20, and another port is connected to the second waveguide 110. The first polarization controller 95 is configured to adjust a polarization state of the first scanning light beam output by the optical splitter 20 to the target polarization state corresponding to the optical microcavity 40. The second polarization controller 96 is disposed between the frequency shifter 30 and the third waveguide 120, and is configured to adjust a polarization state of the third scanning light beam to the target polarization state corresponding to the optical microcavity 40. Alternatively, the second polarization controller 96 may be disposed between the optical splitter 20 and the frequency shifter 30, and is configured to adjust a polarization state of the second scanning light beam to the target polarization state corresponding to the optical microcavity 40.

In some feasible implementations, based on the structures shown in FIG. 9 to FIG. 14, to resolve a stability problem of the target optical frequency comb, similarly, when the optical microcavity 40 generates the target light beam, the detector may be further configured to: detect the target light beam output by the second port of the second waveguide 110, to obtain an optical power of the target light beam, and feed back the optical power of the target light beam to the controller 80. The controller 80 may receive and store the optical power of the target light beam. Then, the detector 70 may continue to detect an optical power of the light beam output by the second port of the second waveguide 110, and feed back the optical power detected by the detector 70 to the controller 80. The controller 80 is configured to determine, based on the optical power fed back by the detector 70 and the optical power that is of the target light beam and that is pre-stored in the controller 80, whether the optical power of the light beam output by the second port of the second waveguide 110 changes (in other words, determine whether the light beam output by the second port of the second waveguide 110 is still the target light beam). For a specific process, refer to the foregoing described process in which the controller 80 determines, based on the optical power fed back by the detector 70 and the optical power that is of the target light beam and that is pre-stored in the controller 80, whether the optical power of the light beam output by the third port of the circulator 60 changes. Details are not described herein again. Then, when it is determined that the optical power of the light beam output by the second port of the second waveguide 110 changes, the controller 80 is further configured to control the frequency shifter 30 to change the frequency of the third scanning light beam again until the optical power of the light beam output by the second port of the second waveguide 110 is restored to the optical power of the target light beam (in other words, until it is determined again that the light beam output by the second port of the second waveguide 110 is the target light beam). For a specific process, refer to the foregoing described specific process in which "the controller 80 controls the frequency shifter 30 to change the frequency of the third scanning light beam again until the optical power of the light beam output by the third port of the circulator 60 is restored to the optical power of the target light beam". Details are not described herein again.

In the foregoing implementation, when the optical power of the light beam output by the second port of the second waveguide 110 changes (in other words, the optical power of the light beam is no longer the optical power of the target light beam), the controller 80 may be used to control the frequency shifter 30 to change the frequency of the third scanning light beam, to enable the optical power of the light beam output by the second port of the second waveguide 110 to be restored to the optical power of the target light beam. In this way, it can be ensured that the optical frequency comb generation device 100 can continuously and stably output the target optical frequency comb, and applicability of the optical frequency comb generation device 100 can be improved.

In some feasible implementations, the laser device 10 may use a sub-hertz linewidth laser device, so that a linewidth of the target optical frequency comb output by the optical frequency comb generation device 100 can be maintained at a sub-hertz level. Herein, the sub-hertz is a range of 0 to 1 hertz.

It should be additionally noted herein that, in some application scenarios, the first scanning light beam described above may also be referred to as pump light, and the third scanning light beam described above may also be referred to as auxiliary light. An optical frequency comb generated by the optical microcavity 40 may also be referred to as a Kerr optical frequency comb, and the target optical frequency comb may also be referred to as a dissipative soliton mode-locked Kerr optical comb.

It should be further noted herein that, the foregoing connections between the components may include a physical optical connection or an optical connection in space optics, for example, an optical connection established through a waveguide or another optical conduction component, or an optical connection established through a spatial light field. For example, the laser device 10 and the optical splitter 20 may establish a connection through a spatial light field, or may establish an optical connection through an optical fiber. In addition, the connections between the components may further include an electrical connection. For example, an electrical connection is established between the controller 80 and the laser device 10, to implement transmission of an electrical signal between the controller 80 and the laser device 10. A specific connection manner between the components may be determined based on actual transmission requirements of the components. This is not limited in this application.

## Embodiment 2

FIG. 15 is a schematic flowchart of an optical frequency comb generation method according to an embodiment of this application. The optical frequency comb generation method is applicable to the optical frequency comb generation device 100 described in Embodiment 1. In this embodiment, for a specific structure and function of the optical frequency comb generation device 100, refer to the corresponding descriptions in Embodiment 1. Details are not described in this embodiment again. As shown in FIG. 15, the coherent light receiving method may specifically include the following steps:

S151: Generate, through a laser device, a source scanning light beam whose frequency changes in a first direction, and transmit the source scanning light beam to an optical splitter.

In some feasible implementations, the optical frequency comb generation device 100 may generate, through the laser device 10, the source scanning light beam whose frequency changes in the first direction, and transmit the source scanning light beam to the optical splitter 20. Specifically, the optical frequency comb generation device 100 may transmit a first control signal to the laser device 10 through a controller 80 included in the optical frequency comb generation device 100, to control the laser device 10 to generate the source scanning light beam. For a specific control process, refer to the process in which the controller 80 controls the laser device 10 to generate the source scanning light beam described in Embodiment 1. Details are not described herein again.

S152: Split, through the optical splitter, the source scanning light beam into a first scanning light beam and a second scanning light beam, transmit the first scanning light beam to an optical microcavity, and transmit the second scanning light beam to a frequency shifter.

In some feasible implementations, after receiving the source scanning light beam, the optical splitter 20 may split the source scanning light beam into the first scanning light beam and the second scanning light beam. Then, the first scanning light beam is transmitted to the optical microcavity 40, and the second scanning light beam is transmitted to the frequency shifter 30. An optical power of the first scanning light beam needs to be greater than or equal to a nonlinear effect power threshold of the optical microcavity 40. Herein, for a specific process in which the optical splitter 20 performs splitting and transmits the first scanning light beam and the second scanning light beam, refer to the descriptions in Embodiment 1. Details are not described herein again.

In an optional implementation, in a scenario in which the optical frequency comb generation device 100 uses the structure shown in FIG. 3, the optical frequency comb generation device 100 specifically transmits the first scanning light beam to the optical microcavity 40 through a first waveguide 50. Herein, for a process of transmitting the first scanning light beam to the optical microcavity 40 through the first waveguide 50, refer to a corresponding process described above. Details are not described herein again. In addition, the optical frequency comb generation device 100 still transmits a third scanning light beam to the optical microcavity 40 through the first waveguide 50 and a circulator 60. For a specific process, refer to a corresponding process described above. Details are not described herein again.

Further, when the optical frequency comb generation device 100 further includes a first amplifier 91 and a second amplifier 92, the optical frequency comb generation device 100 may adjust, through the first amplifier 91, the optical power of the first scanning light beam from the optical splitter 20, and then transmit the first scanning light beam obtained after optical power adjustment to the first waveguide 50. Herein, an optical power of the first scanning light beam obtained after the optical power adjustment is greater than or equal to the nonlinear effect power threshold of the optical microcavity 40. In addition, the optical frequency comb generation device 100 may further adjust, through the second amplifier 92, an optical power of the second scanning light beam from the optical splitter 20, and then transmit the second scanning light beam obtained after optical power adjustment to the frequency shifter 30. Herein, for a specific process of adjusting the optical power of the first scanning light beam through the first amplifier 91 and adjusting the optical power of the second scanning light beam through the second amplifier 92, refer to the descriptions of the functions of the first amplifier 91 and the second amplifier 92 in Embodiment 1. Details are not described herein again.

Further, when the optical frequency comb generation device 100 further includes a first filter 93 and a second filter 94, the optical frequency comb generation device 100 may perform, through the first filter 93, noise filtering on the first scanning light beam output by the first amplifier 91 after the optical power adjustment, and then transmit the first scanning light beam obtained after the noise filtering to the first waveguide 50. In addition, the optical frequency comb generation device 100 may further perform, through the second filter 94, noise filtering on the second scanning light beam output by the second amplifier 92 after the optical power adjustment, and transmit the second scanning light beam obtained after the noise filtering to the frequency shifter 30. Herein, for a specific process of filtering out noise of the first scanning light beam through the first filter 93 and filtering out noise of the second scanning light beam through the second filter 94, refer to the descriptions of the functions of the first filter 93 and the second filter 94 in Embodiment 1. Details are not described herein again.

Further, when the optical frequency comb generation device 100 further includes a first polarization controller 95, the optical frequency comb generation device 100 may first adjust, through the first polarization controller 95, a polarization state of the first scanning light beam obtained after the noise filtering to a target polarization state of the optical microcavity 40, and then transmit the first scanning light beam obtained after polarization state adjustment to the first waveguide 50. For a specific process, refer to the descriptions of the function of the first polarization controller 95 in Embodiment 1. Details are not described herein again.

In another optional implementation, in a scenario in which the optical frequency comb generation device 100 uses the structure shown in FIG. 9, the optical frequency comb generation device 100 specifically transmits the first scanning light beam to the optical microcavity 40 through a second waveguide 110. In addition, the optical frequency comb generation device 100 still transmits a third scanning light beam to the optical microcavity 40 through a third waveguide 120. For a specific process, refer to a corresponding process described in Embodiment 1. Details are not described herein again.

Further, when the optical frequency comb generation device 100 further includes a first amplifier 91 and a second amplifier 92, the optical frequency comb generation device 100 may adjust the optical power of the first scanning light beam through the first amplifier 91, and then transmit the first scanning light beam obtained after optical power adjustment to the second waveguide 110. An optical power of the first scanning light beam obtained after the optical power adjustment is greater than or equal to the nonlinear effect power threshold of the optical microcavity 40. In addition, the optical frequency comb generation device 100 may further adjust an optical power of the second scanning light beam through the second amplifier 92, and then transmit the second scanning light beam obtained after optical power adjustment to the frequency shifter 30. For a specific process, refer to the descriptions of the functions of the first amplifier 91 and the second amplifier 92 in Embodiment 1. Details are not described herein again.

Further, when the optical frequency comb generation device 100 further includes a first filter 93 and a second filter 94, the optical frequency comb generation device 100 may first perform, through the first filter 93, noise filtering on the first scanning light beam obtained after the optical power adjustment, and then transmit the first scanning light beam obtained after the noise filtering to the second waveguide 110. In addition, the optical frequency comb generation device 100 may further first perform, through the second filter 94, noise filtering on the second scanning light beam obtained after the optical power adjustment, and then transmit the second scanning light beam obtained after the noise filtering to the frequency shifter 30. For a specific process, refer to the descriptions of the functions of the first filter 93 and the second filter 94 in Embodiment 1. Details are not described herein again.

Further, when the optical frequency comb generation device 100 further includes a first polarization controller 95, the optical frequency comb generation device 100 may adjust, through the first polarization controller 95, a polarization state of the first scanning light beam obtained after the noise filtering to a target polarization state of the optical microcavity 40, and then transmit the first scanning light beam obtained after polarization state adjustment to the second waveguide 110. For a specific process, refer to the descriptions of the function of the first polarization controller 95 in Embodiment 1. Details are not described herein again.

S 153: Generate, through the frequency shifter based on the second scanning light beam, the third scanning light beam whose frequency changes in a second direction, and send the third scanning light beam to the optical microcavity.

In some feasible implementations, after obtaining the second scanning light beam, the optical frequency comb generation device 100 may further generate, through the frequency shifter 30 based on the second scanning light beam, the third scanning light beam whose frequency changes in the second direction. Herein, for a specific process of generating the third scanning light beam through the frequency shifter 30 based on the second scanning light beam, refer to the specific process in which the frequency shifter 30 generates the third scanning light beam based on the second scanning light beam described in Embodiment 1. Details are not described herein again.

After obtaining the third scanning light beam, the optical frequency comb generation device 100 may send the third scanning light beam to the optical microcavity 40 through the frequency shifter 30.

Optionally, when the optical frequency comb generation device 100 uses the structure shown in FIG. 3 and further includes a second polarization controller 96, the optical frequency comb generation device 100 may first adjust, through the second polarization controller 96, a polarization state of the third scanning light beam to the target polarization state, and then transmit the third scanning light beam obtained after polarization state adjustment to the optical microcavity 40 through the circulator 60. For a specific process, refer to the descriptions, in Embodiment 1, of the function of the second polarization controller 96 in a case in which the optical frequency comb generation device 100 uses the structure shown in FIG. 3. Details are not described herein again.

Optionally, when the optical frequency comb generation device 100 uses the structure shown in FIG. 9 and further includes a second polarization controller 96, the optical frequency comb generation device 100 may first adjust, through the second polarization controller 96, a polarization state of the third scanning light beam to the target polarization state, and then transmit the third scanning light beam obtained after polarization state adjustment to the optical microcavity 40 through the third waveguide 120. For a specific process, refer to the descriptions, in Embodiment 1, of the function of the second polarization controller 96 in a case in which the optical frequency comb generation device 100 uses the structure shown in FIG. 9. Details are not described herein again.

S154: Generate, through the optical microcavity, a target light beam when the first scanning light beam is in a red detuning region of the optical microcavity and the third scanning light beam is in a blue detuning region of the optical microcavity.

In some feasible implementations, the optical frequency comb generation device 100 may continuously receive the first scanning light beam and the third scanning light beam through the optical microcavity 40. Then, as time elapses, the first scanning light beam is in the red detuning region of the optical microcavity 40 and the third scanning light beam is in the blue detuning region of the optical microcavity 40. In this case, the optical frequency comb generation device 100 may generate and output the target light beam through the optical microcavity 40. Herein, a spectrum of the target light beam is a required target optical frequency comb. Herein, for a process in which the optical frequency comb generation device 100 generates the target light beam through the optical microcavity 40, refer to the descriptions of the process in which the optical microcavity 40 generates the target light beam in Embodiment 1. Details are not described herein again.

In an optional implementation, in the scenario in which the optical frequency comb generation device 100 uses the structure shown in FIG. 3, after determining that a light beam output by a third port of the circulator 60 is the target light beam, the optical frequency comb generation device 100 may further determine, through a detector 70 and the controller 80, whether an optical power of the light beam output by the third port of the circulator 60 changes. For a specific process, refer to the process in which the detector 70 and the controller 80 determine whether the optical power of the light beam output by the third port of the circulator 60 changes described in Embodiment 1. Details are not described herein again. When it is determined that the optical power of the light beam output by the third port of the circulator 60 changes, the controller 80 is used to control the frequency shifter 30 to change the frequency of the third scanning light beam until the optical power of the light beam output by the third port of the circulator 60 is restored to an optical power of the target light beam. For a specific process, refer to a corresponding process described in Embodiment 1. Details are not described herein again.

In another optional implementation, in the scenario in which the optical frequency comb generation device 100 uses the structure shown in FIG. 9, after determining that a light beam output by a second port of the second waveguide 110 is the target light beam, the optical frequency comb generation device 100 may further determine, through a detector 70 and the controller 80, whether an optical power of the light beam output by the second port of the second waveguide 110 changes. For a specific process, refer to the process in which the detector 70 and the controller 80 determine whether the optical power of the light beam output by the second port of the second waveguide 110 changes described in Embodiment 1. Details are not described herein again. When it is determined that the optical power of the light beam output by the second port of the second waveguide 110 changes, the controller 80 is used to control the frequency shifter 30 to change the frequency of the third scanning light beam until the optical power of the light beam output by the second port of the second waveguide 110 is restored to an optical power of the target light beam. For a specific process, refer to a corresponding process described in Embodiment 1. Details are not described herein again.

In the optical frequency comb generation method provided in this application, the optical microcavity 40 is scanned by using both the first scanning light beam and the third scanning light beam that have a same source, so that three types of noise, to be specific, a random change of an optical frequency comb spacing that is caused by a detuning amount jitter of the first scanning light beam, an optical frequency comb frequency jitter caused by a frequency jitter of the laser device 10, and an optical frequency comb frequency jitter caused by a resonance frequency jitter, are reduced or eliminated. In this way, the target optical frequency comb with a very narrow linewidth can be obtained, and applicability and practicability of the optical frequency comb generation method can be improved.

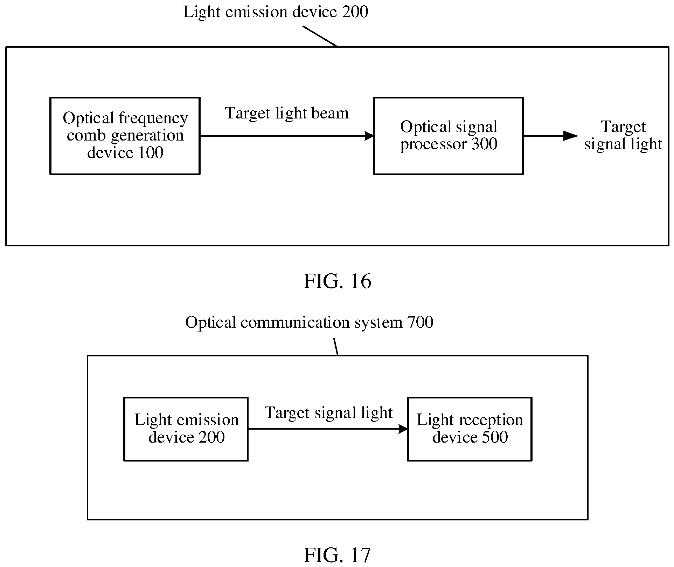

This application further provides a light emission device. FIG. 16 is a schematic diagram of a structure of a light emission device according to an embodiment of this application. As shown in FIG. 16, the light emission device 200 may include the optical frequency comb generation device 100 described above and an optical signal processor 300. The optical frequency comb generation device 100 is connected to the optical signal processor 300. During actual work, the optical frequency comb generation device 100 is used as a light source of the light emission device 200, and is configured to generate a target light beam and send the target light beam to the optical signal processor 300. The optical signal processor 300 is configured to: receive the target light beam, and perform optical modulation on the target light beam, to obtain and output corresponding target signal light.

It should be noted that FIG. 16 shows only two functional components: the optical frequency comb generation device 100 and the optical signal processor 300 that are included in the light emission device 200. During actual implementation, the light emission device 200 may further include other components such as a power supply, a microprocessor, and an analog-to-digital converter (analog-to-digital converter, ADC). A specific structure of the light emission device 200 is not limited in this application.

During actual application, the light emission device 200 may be specifically an optical transmitter in a coherent optical communication system, or may be an integrated light source in a laser radar. A product form of the light emission device 200 is not limited in this application. The optical signal processor 300 may be specifically a digital signal processor, or a processor of another type, for example, a general-purpose processor, an application-specific integrated circuit, a field programmable gate array or another programmable logic device, a discrete gate or transistor logic device, or a discrete hardware component. This is not limited in this application.

An embodiment of this application further provides an optical communication system. FIG. 17 is a schematic diagram of a structure of an optical communication system according to an embodiment of this application. As shown in FIG. 17, the optical communication system 700 may include the light emission device 200 described above and a light reception device 500. The light emission device 200 and the light reception device 500 are connected to each other. During actual work, the light emission device 200 is configured to: generate target signal light based on a target light beam generated by the optical frequency comb generation device 100 and to-be-transmitted data, and transmit the target signal light to the light reception device 500. The light reception device 500 is configured to: receive the target signal light, and process the target signal light to obtain the to-be-transmitted data.

It should be understood that, during actual application, the optical communication system 700 may be specifically a coherent optical communication system, or may be an optical communication system of another type. This is not specifically limited in this application.

In embodiments provided in this application, it should be understood that the disclosed system, apparatus, or method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, that is, may be located at one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

In the specification, claims, and accompanying drawings of this application, terms such as "first", "second", "third", and "fourth" are intended to distinguish between different objects, but do not indicate a specific order. In addition, terms "include" and "have" and any other variants thereof are intended to cover non-exclusive inclusion. For example, a process, method, system, product, or device that includes a series of steps or units is not limited to the listed steps or units, but optionally further includes an unlisted step or unit, or optionally further includes another inherent step or unit of the process, method, product, or device.

"An embodiment" mentioned in the specification indicates that a particular characteristic, structure or feature described with reference to this embodiment may be included in at least one embodiment of this application. The phrase appearing in various locations in the specification does not necessarily mean a same embodiment, and neither means an independent or alternative embodiment mutually exclusive with another embodiment. It is explicitly and implicitly understood by a person skilled in the art that embodiments described in the specification may be combined with another embodiment.

A person skilled in the art should be aware that in one or more of the foregoing examples, the functions described in this application may be implemented by using hardware, software, firmware, or any combination thereof. When the software is used to implement the functions, the functions may be stored in a computer-readable medium or transmitted as one or more instructions or code in the computer-readable medium. The computer-readable medium includes a computer storage medium and a communication medium, where the communication medium includes any medium that enables a computer program to be transmitted from one place to another. The storage medium may be any available medium accessible to a general-purpose or dedicated computer.

In the foregoing specific implementations, the objectives, technical solutions, and beneficial effect of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

**Claims**

1. An optical frequency comb generation device, wherein the device comprises a laser device, an optical splitter, a frequency shifter, and an optical microcavity;

   the laser device is configured to: generate a source scanning light beam whose frequency changes in a first direction, and transmit the source scanning light beam to the optical splitter;
   the optical splitter is configured to: split the source scanning light beam into a first scanning light beam and a second scanning light beam, transmit the first scanning light beam to the optical microcavity, and transmit the second scanning light beam to the frequency shifter, wherein an optical power of the first scanning light beam is greater than or equal to a nonlinear effect power threshold of the optical microcavity;
   the frequency shifter is configured to: change a frequency of the second scanning light beam to generate a third scanning light beam whose frequency changes in a second direction, and transmit the third scanning light beam to the optical microcavity; and
   the optical microcavity is configured to generate a target light beam when the first scanning light beam is in a red detuning region of the optical microcavity and the third scanning light beam is in a blue detuning region of the optical microcavity, wherein a spectrum of the target light beam is a target optical frequency comb.

2. The device according to claim 1, wherein the first scanning light beam and the third scanning light beam are transmitted in opposite directions in the optical microcavity.

3. The device according to claim 1 or 2, wherein a frequency change speed of the third scanning light beam is greater than or equal to a frequency change speed of the first scanning light beam.

4. The device according to any one of claims 1 to 3, wherein the device further comprises a first waveguide and a circulator;

   a first port of the optical splitter is connected to the laser device, a second port of the optical splitter is connected to a first port of the first waveguide, a second port of the first waveguide is connected to a first port of the circulator, and the optical microcavity is coupled between the first port and the second port of the first waveguide;
   a third port of the optical splitter is connected to a first port of the frequency shifter, and a second port of the frequency shifter is connected to a second port of the circulator; and
   the first waveguide is configured to transmit the first scanning light beam to the optical microcavity, the first waveguide and the circulator are configured to transmit the third scanning light beam to the optical microcavity, and a third port of the circulator is configured to output the target light beam.

5. The device according to claim 4, wherein the device further comprises a first amplifier and a second amplifier;

   the second port of the optical splitter is connected to the first port of the first waveguide through the first amplifier, and the first amplifier is configured to: adjust the optical power of the first scanning light beam, and transmit the first scanning light beam obtained after optical power adjustment to the first waveguide, wherein an optical power of the first scanning light beam obtained after the optical power adjustment is greater than or equal to the nonlinear effect power threshold; and
   the third port of the optical splitter is connected to the first port of the frequency shifter through the second amplifier, and the second amplifier is configured to: adjust an optical power of the second scanning light beam, and transmit the second scanning light beam obtained after optical power adjustment to the frequency shifter.

**6.** The device according to claim 5, wherein the device further comprises a first filter and a second filter;

the first amplifier is connected to the first port of the first waveguide through the first filter, and the first filter is configured to: perform noise filtering on the first scanning light beam, and transmit the first scanning light beam obtained after the noise filtering to the first waveguide; and

the second amplifier is connected to the frequency shifter through the second filter, and the second filter is configured to: perform noise filtering on the second scanning light beam, and transmit the second scanning light beam obtained after the noise filtering to the frequency shifter.

**7.** The device according to claim 6, wherein the device further comprises a first polarization controller and a second polarization controller;

the first filter is connected to the first port of the first waveguide through the first polarization controller, and the first polarization controller is configured to: adjust a polarization state of the first scanning light beam to a target polarization state corresponding to the optical microcavity, and transmit the first scanning light beam obtained after polarization state adjustment to the first waveguide; and

the frequency shifter is connected to the second port of the circulator through the second polarization controller, and the second polarization controller is configured to: adjust a polarization state of the third scanning light beam to the target polarization state, and transmit the third scanning light beam obtained after polarization state adjustment to the circulator.

**8.** The device according to any one of claims 4 to 7, wherein the device further comprises a detector and a controller;

the detector is connected to the third port of the circulator, and the controller is connected to the laser device, the frequency shifter, and the detector;

the detector is configured to detect a light beam output by the third port of the circulator; and

when the light beam output by the third port of the circulator is the target light beam, the controller is configured to: control the laser device to stop a change of the frequency of the source scanning light beam, and control the frequency shifter to stop a change of the frequency of the third scanning light beam.

**9.** The device according to claim 8, wherein after the light beam output by the third port of the circulator is the target light beam, when an optical power of the light beam output by the third port of the circulator changes, the controller is further configured to control the frequency shifter to change the frequency of the third scanning light beam until the optical power of the light beam output by the third port of the circulator is restored to an optical power of the target light beam.

**10.** The device according to any one of claims 1 to 3, wherein the device further comprises a second waveguide and a third waveguide;

a first port of the optical splitter is connected to the laser device, a second port of the optical splitter is connected to a first port of the second waveguide, and the optical microcavity is coupled between the first port and a second port of the second waveguide;

a third port of the optical splitter is connected to a first port of the frequency shifter, a second port of the frequency shifter is connected to a first port of the third waveguide, and the optical microcavity is coupled between the first port and a second port of the third waveguide; and

the second waveguide is configured to transmit the first scanning light beam to the optical microcavity, the third waveguide is configured to transmit the third scanning light beam to the optical microcavity, and the second port of the second waveguide is configured to output the target light beam.

**11.** The device according to claim 10, wherein the device further comprises a first amplifier and a second amplifier;

the second port of the optical splitter is connected to the first port of the second waveguide through the first amplifier, and the first amplifier is configured to: adjust the optical power of the first scanning light beam, and transmit the first scanning light beam obtained after optical power adjustment to the second waveguide, wherein an optical power of the first scanning light beam obtained after the optical power adjustment is greater than or equal to the nonlinear effect power threshold; and

the third port of the optical splitter is connected to the first port of the frequency shifter through the second amplifier, and the second amplifier is configured to: adjust an optical power of the second scanning light beam, and transmit the second scanning light beam obtained after optical power adjustment to the frequency shifter.

12. The device according to claim 11, wherein the device further comprises a first filter and a second filter;

the first amplifier is connected to the second waveguide through the first filter, and the first filter is configured to: perform noise filtering on the first scanning light beam, and transmit the first scanning light beam obtained after the noise filtering to the second waveguide; and
the second amplifier is connected to the first port of the frequency shifter through the second filter, and the second filter is configured to: perform noise filtering on the second scanning light beam, and transmit the second scanning light beam obtained after the noise filtering to the frequency shifter.

13. The device according to claim 12, wherein the device further comprises a first polarization controller and a second polarization controller;

the first filter is connected to the first port of the second waveguide through the first polarization controller, and the first polarization controller is configured to: adjust a polarization state of the first scanning light beam to a target polarization state of the optical microcavity, and transmit the first scanning light beam obtained after polarization state adjustment to the second waveguide; and
the frequency shifter is connected to the first port of the third waveguide through the second polarization controller, and the second polarization controller is configured to: adjust a polarization state of the third scanning light beam to the target polarization state, and transmit the third scanning light beam obtained after polarization state adjustment to the third waveguide.

14. The device according to any one of claims 10 to 13, wherein the device further comprises a detector and a controller;

the detector is connected to the second port of the second waveguide, and the controller is connected to the laser device, the frequency shifter, and the detector;
the detector is configured to detect a light beam output by the second port of the third waveguide; and
when the light beam output by the second port of the third waveguide is the target light beam, the controller is configured to: control the laser device to stop a change of the frequency of the source scanning light beam, and control the frequency shifter to stop a change of the frequency of the third scanning light beam.

15. The device according to claim 14, wherein after the light beam output by the second port of the third waveguide is the target light beam, when an optical power of a light beam output by the second port of the second waveguide changes, the controller is further configured to control the frequency shifter to change the frequency of the third scanning light beam until the optical power of the light beam output by the second port of the second waveguide is restored to an optical power of the target light beam.

16. An optical frequency comb generation method, wherein the method is applicable to an optical frequency comb generation device, the device comprises a laser device, an optical splitter, a frequency shifter, and an optical microcavity, and the method comprises:

generating, through the laser device, a source scanning light beam whose frequency changes in a first direction, and transmitting the source scanning light beam to the optical splitter;
splitting, through the optical splitter, the source scanning light beam into a first scanning light beam and a second scanning light beam, transmitting the first scanning light beam to the optical microcavity, and transmitting the second scanning light beam to the frequency shifter, wherein an optical power of the first scanning light beam is greater than or equal to a nonlinear effect power threshold of the optical microcavity;
generating, through the frequency shifter based on the second scanning light beam, a third scanning light beam whose frequency changes in a second direction, and sending the third scanning light beam to the optical microcavity; and
generating, through the optical microcavity, a target light beam when the first scanning light beam is in a red detuning region of the optical microcavity and the third scanning light beam is in a blue detuning region of the optical microcavity, wherein a spectrum of the target light beam is a target optical frequency comb.

17. The method according to claim 16, wherein the first scanning light beam and the third scanning light beam are transmitted in opposite directions in the optical microcavity.

18. The method according to claim 16 or 17, wherein a frequency change speed of the third scanning light beam is greater than or equal to a frequency change speed of the first scanning light beam.

19. The method according to any one of claims 16 to 18, wherein the device further comprises a first waveguide and a circulator;
the transmitting the first scanning light beam to the optical microcavity comprises:

transmitting the first scanning light beam to the optical microcavity through the first waveguide; and
the sending the third scanning light beam to the optical microcavity comprises:
sending the third scanning light beam to the optical microcavity through the first waveguide and the circulator.

20. The method according to claim 19, wherein the device further comprises a detector and a controller; and
the method further comprises:

detecting, through the detector, a light beam output by a third port of the circulator; and
when it is determined that the light beam output by the third port of the circulator is the target light beam, controlling, through the controller, the laser device to stop a change of the frequency of the source scanning light beam, and controlling the frequency shifter to stop a change of the frequency of the third scanning light beam.

21. The method according to claim 20, wherein after determining that the light beam output by the third port of the circulator is the target light beam, the method further comprises:
when it is determined that an optical power of the light beam output by the third port of the circulator changes, controlling, through the controller, the frequency shifter to change the frequency of the third scanning light beam until the optical power of the light beam output by the third port of the circulator is restored to an optical power of the target light beam.

22. The method according to any one of claims 16 to 18, wherein the device further comprises a second waveguide and a third waveguide;
the transmitting the first scanning light beam to the optical microcavity comprises:

transmitting the first scanning light beam to the optical microcavity through the second waveguide; and
the sending the third scanning light beam to the optical microcavity comprises:
transmitting the third scanning light beam to the optical microcavity through the third waveguide.

23. The method according to claim 22, wherein the device further comprises a detector and a controller; and
the method further comprises:

detecting, through the detector, a light beam output by a second port of the second waveguide; and
when it is determined that the light beam output by the second port of the second waveguide is the target light beam, controlling, through the controller, the laser device to stop a change of the frequency of the source scanning light beam, and controlling the frequency shifter to stop a change of the frequency of the third scanning light beam.

24. The method according to claim 23, wherein after determining that the light beam output by the second port of the second waveguide is the target light beam, the method further comprises:
when it is determined that an optical power of the light beam output by the second port of the second waveguide changes, controlling, through the controller, the frequency shifter to change the frequency of the third scanning light beam until the optical power of the light beam output by the second port of the second waveguide is restored to an optical power of the target light beam.

25. The method according to any one of claims 19 to 24, wherein the device further comprises a first amplifier and a second amplifier; and
the method further comprises:

adjusting the optical power of the first scanning light beam through the first amplifier, wherein an optical power of the first scanning light beam obtained after optical power adjustment is greater than or equal to the nonlinear effect power threshold; and
adjusting an optical power of the second scanning light beam through the second amplifier.

26. The method according to claim 25, wherein the device further comprises a first filter and a second filter; and
the method further comprises:

performing, through the first filter, noise filtering on the first scanning light beam obtained after the optical power adjustment; and

performing, through the second filter, noise filtering on the second scanning light beam obtained after optical power adjustment.

27. The method according to claim 26, wherein the device further comprises a first polarization controller and a second polarization controller; and

the method further comprises:

adjusting, through the first polarization controller, a polarization state of the first scanning light beam obtained after the noise filtering to a target polarization state of the optical microcavity; and

adjusting, through the second polarization controller, a polarization state of the third scanning light beam to the target polarization state.

28. A light emission device, wherein the light emission device comprises the optical frequency comb generation device according to any one of claims 1 to 15 and an optical signal processor;

the optical frequency comb generation device is configured to generate a target light beam, wherein a spectrum of the target light beam is a target optical frequency comb; and

the optical signal processor is configured to modulate the target light beam and output target signal light.

29. An optical communication system, wherein the optical communication system comprises the light emission device according to claim 28 and a light reception device; and

the light emission device is configured to generate and transmit target signal light to the light reception device.

Optical frequency comb generation device 100

FIG. 1

Resonance spectrum of an optical microcavity

FIG. 2

Optical frequency comb generation device 100

FIG. 3

Optical frequency comb generation device 100

FIG. 4

Optical frequency comb generation device 100

FIG. 5

Optical frequency comb generation device 100

FIG. 6

Optical frequency comb generation device 100

FIG. 7

Optical frequency comb generation device 100

Source
scanning
light
beam

First
scanning
light
beam

First polarization
controller 95

Optical microcavity 40

First waveguide 50

Target light
beam

Laser
device
10

Optical
splitter
20

Third
scanning
light
beam

Circulator
60

Detector
70

Second scanning
light beam

Frequency
shifter 30

Second polarization
controller 96

Controller
80

FIG. 8

Optical frequency comb generation device 100

Source
scanning
light beam

First
scanning
light beam

Second
waveguide 110

Target
light beam

Laser
device
10

Optical
splitter 20

Second
scanning
light beam

Frequency
shifter 30

Third
scanning
light beam

Optical
microcavity
40

Third
waveguide 120

FIG. 9

Optical frequency comb generation device 100

FIG. 10

Optical frequency comb generation device 100

FIG. 11

Optical frequency comb generation device 100

FIG. 12

Optical frequency comb generation device 100

FIG. 13

Optical frequency comb generation device 100

FIG. 14

| Generate, through a laser device, a source scanning light beam whose frequency changes in a first direction, and transmit the source scanning light beam to an optical splitter | S151 |
|---|---|
| Split, through the optical splitter, the source scanning light beam into a first scanning light beam and a second scanning light beam, transmit the first scanning light beam to an optical microcavity, and transmit the second scanning light beam to a frequency shifter | S152 |
| Generate, through the frequency shifter based on the second scanning light beam, a third scanning light beam whose frequency changes in a second direction, and send the third scanning light beam to the optical microcavity | S153 |
| Generate, through the optical microcavity, a target light beam when the first scanning light beam is in a red detuning region of the optical microcavity and the third scanning light beam is in a blue detuning region of the optical microcavity | S154 |

FIG. 15

Light emission device 200

Optical frequency comb generation device 100 → Target light beam → Optical signal processor 300 → Target signal light

FIG. 16

Optical communication system 700

Light emission device 200 → Target signal light → Light reception device 500

FIG. 17

## INTERNATIONAL SEARCH REPORT

| | International application No. |
|---|---|
| | **PCT/CN2023/080690** |

**A.    CLASSIFICATION OF SUBJECT MATTER**

H01S3/10(2006.01)i;G02F1/35(2006.01)i

According to International Patent Classification (IPC) or to both national classification and IPC

**B.    FIELDS SEARCHED**

Minimum documentation searched (classification system followed by classification symbols)

IPC:H01S3,G02F1

Documentation searched other than minimum documentation to the extent that such documents are included in the fields searched

Electronic data base consulted during the international search (name of data base and, where practicable, search terms used)

CNTXT; ENTXTC; WPABSC; VEN: 光频梳, 频率梳, 移频, 频移, 微腔, 微盘, 微环, 失谐, optical frequency comb, frequency shifter, frequency transfer, microring, microdisk, microcavity, microresonator, mismatching

**C.    DOCUMENTS CONSIDERED TO BE RELEVANT**

| Category* | Citation of document, with indication, where appropriate, of the relevant passages | Relevant to claim No. |
|---|---|---|
| A | CN 111897175 A (XI'AN INSTITUTE OF OPTICS AND PRECISION MECHANICS, CHINESE ACADEMY OF SCIENCES) 06 November 2020 (2020-11-06) description, paragraphs [0039]-[0046], and figure 1 | 1-29 |
| A | CN 112582858 A (JINAN INSTITUTE OF QUANTUM TECHNOLOGY) 30 March 2021 (2021-03-30) entire document | 1-29 |
| A | US 2022026780 A1 (HUAWEI TECHNOLOGIES CO., LTD.) 27 January 2022 (2022-01-27) entire document | 1-29 |
| A | CN 107144984 A (NANJING UNIVERSITY OF POSTS AND TELECOMMUNICATIONS) 08 September 2017 (2017-09-08) entire document | 1-29 |
| A | CN 108616030 A (XI'AN INSTITUTE OF OPTICS AND PRECISION MECHANICS, CHINESE ACADEMY OF SCIENCES) 02 October 2018 (2018-10-02) entire document | 1-29 |
| A | CN 111987580 A (HUAWEI TECHNOLOGIES CO., LTD.) 24 November 2020 (2020-11-24) entire document | 1-29 |

☑ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 May 2023** | **31 May 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/080690**

**C.     DOCUMENTS CONSIDERED TO BE RELEVANT**

| Category* | Citation of document, with indication, where appropriate, of the relevant passages | Relevant to claim No. |
|---|---|---|
| A | CN 113485035 A (UNIVERSITY OF SCIENCE AND TECHNOLOGY OF CHINA) 08 October 2021 (2021-10-08) entire document | 1-29 |
| A | CN 103001114 A (GUANGDONG HANTANG QUANTUM OPTOELECTRONICS TECHNOLOGY CO., LTD.) 27 March 2013 (2013-03-27) entire document | 1-29 |
| A | JP 2021092740 A (XTIA CO., LTD.) 17 June 2021 (2021-06-17) entire document | 1-29 |
| A | US 2018083414 A1 (PURDUE RESEARCH FOUNDATION) 22 March 2018 (2018-03-22) entire document | 1-29 |
| A | US 2018307118 A1 (COMMISSARIAT A L'ENERGIE ATOMIQUE ET AUX ENERGIES ALTERNATIVES) 25 October 2018 (2018-10-25) entire document | 1-29 |
| A | US 9891500 B1 (CITY UNIVERSITY OF HONG KONG) 13 February 2018 (2018-02-13) entire document | 1-29 |
| A | DAI, Weiyu et al. "Microwave Photonic Filter by Using Recirculating Frequency Shifter to Generate Optical Frequency Comb" *IEEE photonics journal*, Vol. 13, No. 2, 30 April 2021 (2021-04-30), entire document | 1-29 |

Form PCT/ISA/210 (second sheet) (July 2022)

INTERNATIONAL SEARCH REPORT

Information on patent family members

International application No.

**PCT/CN2023/080690**

| Patent document cited in search report | | | Publication date (day/month/year) | Patent family member(s) | | | Publication date (day/month/year) |
|---|---|---|---|---|---|---|---|
| CN | 111897175 | A | 06 November 2020 | CN | 111897175 | B | 25 March 2022 |
| CN | 112582858 | A | 30 March 2021 | CN | 112582858 | B | 07 June 2022 |
| US | 2022026780 | A1 | 27 January 2022 | WO | 2020207360 | A1 | 15 October 2020 |
| | | | | EP | 3944014 | A1 | 26 January 2022 |
| | | | | EP | 3944014 | A4 | 25 May 2022 |
| | | | | CN | 111796469 | A | 20 October 2020 |
| | | | | CN | 111796469 | B | 19 August 2022 |
| CN | 107144984 | A | 08 September 2017 | | None | | |
| CN | 108616030 | A | 02 October 2018 | CN | 208336804 | U | 04 January 2019 |
| CN | 111987580 | A | 24 November 2020 | CN | 111987580 | B | 09 November 2021 |
| CN | 113485035 | A | 08 October 2021 | | None | | |
| CN | 103001114 | A | 27 March 2013 | | None | | |
| JP | 2021092740 | A | 17 June 2021 | | None | | |
| US | 2018083414 | A1 | 22 March 2018 | US | 10615566 | B2 | 07 April 2020 |
| US | 2018307118 | A1 | 25 October 2018 | US | 10268100 | B2 | 23 April 2019 |
| | | | | EP | 3385784 | A1 | 10 October 2018 |
| | | | | EP | 3385784 | B1 | 11 January 2023 |
| | | | | FR | 3064078 | A1 | 21 September 2018 |
| | | | | FR | 3064078 | B1 | 24 July 2020 |
| US | 9891500 | B1 | 13 February 2018 | | None | | |

Form PCT/ISA/210 (patent family annex) (July 2022)

**EP 4 475 359 A1**

**REFERENCES CITED IN THE DESCRIPTION**

**Patent documents cited in the description**

- CN 202210265993X